(19) Europäisches Patentamt
European Patent Office
Office européen des brevets

(11) Veröffentlichungsnummer : **0 659 781 A2**

(12) # EUROPÄISCHE PATENTANMELDUNG

(21) Anmeldenummer : **94810719.8**

(22) Anmeldetag : **13.12.94**

(51) Int. Cl.[6] : **C08F 222/40**, C08F 212/04, C08F 220/30, G03F 7/039

(30) Priorität : **21.12.93 CH 279/94**

(43) Veröffentlichungstag der Anmeldung : **28.06.95 Patentblatt 95/26**

(84) Benannte Vertragsstaaten : **BE CH DE FR GB IT LI NL**

(71) Anmelder : **CIBA-GEIGY AG**
**Klybeckstrasse 141**
**CH-4002 Basel (CH)**

(71) Anmelder : **OCG Microelectronic Materials AG**
**Klybeckstrasse 141**
**CH-4002 Basel (CH)**

(72) Erfinder : **Schädeli, Ulrich, Dr.**
**Im Hubel**
**CH-1737 Plasselb (CH)**
Erfinder : **Münzel, Norbert, Dr.**
**Im Clausenfeld 3**
**D-79423 Heitersheim (DE)**
Erfinder : **De Leo, Christoph**
**Kapellenring 30**
**D-79238 Ehrenkirchen (DE)**
Erfinder : **Holzwarth, Heinz**
**St. Blasierweg 2**
**D-79189 Bad Krozingen (DE)**
Erfinder : **Tinguely, Eric**
**Route de Bertigny 41**
**CH-1700 Fribourg (CH)**

(74) Vertreter : **Roueche, Armand et al**
**c/o CIBA-GEIGY AG,**
**Patentabteilung,**
**Postfach**
**CH-4002 Basel (CH)**

(54) **Maleinimidcopolymere, insbesonder für Photoresists.**

(57) Beschrieben werden neue Maleinimidcopolymere, die neben Struktureinheiten, die sich von bestimmten, in der vorliegenden Patentanmeldung näher definierten Maleinimidderivaten ableiten, wiederkehrende Struktureinheiten ausgewählt aus den Struktureinheiten der Formeln (Ia) und (Ib)

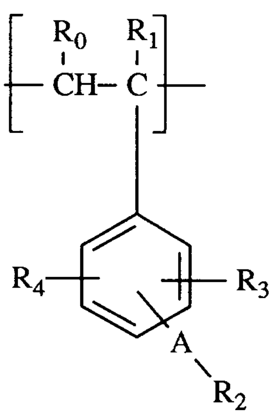

(Ia)

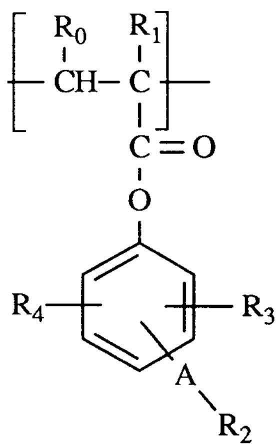

(Ib)

enthalten, wobei in den Formeln (Ia) und (Ib)
A eine direkte Einfachbindung oder eine zweiwertige Gruppe der Formel -O- bedeutet ;
$R_0$ und $R_1$ unabhängig voneinander jeweils ein Wasserstoffatom, eine $C_1$-$C_6$-Alkylgruppe oder eine Arylgruppe mit 6 bis 14 Ringkohlenstoffatomen darstellen ;
$R_2$ einen Rest der Formel

EP 0 659 781 A2

Jouve, 18, rue Saint-Denis, 75001 PARIS

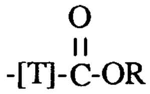 oder 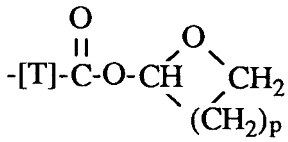

darstellt, worin R für einen tert.-Alkylrest mit 4 bis 19 Kohlenstoffatomen,
[T] für eine $C_1$-$C_6$-Alkylengruppe oder für eine Arylengruppe mit 6 bis 14 Ringkohlenstoffatomen und
p für eine der Zahlen 2,3 oder 4 stehen ; oder
A zusammen mit $R_2$ eine Gruppe der Formel

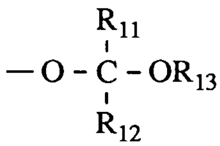

darstellt, wobei weiterhin
$R_3$ sowie $R_4$ unabhängig voneinander jeweils ein Wasserstoffatom, ein Halogenatom, eine $C_1$-$C_6$-Alkylgruppe oder eine $C_1$-$C_6$-Alkoxygruppe darstellen und die weiteren Reste spezifische in der vorliegenden Anmeldung näher definierte Bedeutungen haben. Die Polymere können die Basis von chemisch verstärkten Positivphotoresists bilden, die unter anderem ausgezeichnetes Kontrastverhalten, eine geringe Schrumpfungstendenz an den bestrahlten Partien und keine nennenswerten delay time-Effekte zeigen.

Die vorliegende Erfindung betrifft Polymere auf Basis von bestimmten Styrol- und/oder (Meth)acrylsäurephenolester- sowie Maleinimidderivaten, als Positivphotoresist einsetzbare strahlungsempfindliche Zusammensetzungen enthaltend diese Polymere, ein Verfahren zur Behandlung eines Substrats unter Verwendung dieser Zusammensetzungen sowie ein Verfahren zur Herstellung von elektronischen Bauelementen, das daszuvor genannte Verfahren umfasst.

In der EP-A 410 794 sind bereits Negativphotoresists für Strahlung im tiefen UV-Bereich, d. h. für Strahlung einer Wellenlänge von ca. 200-300 nm beschrieben, die bestimmte Polymere auf Basis von Styrol- und Maleinimidderivaten enthalten. Diese Negativresists können wässerig-alkalisch entwickelt werden. Negativresists sind jedoch im allgemeinen zur Abbildung von bestimmten geometrischen Strukturen weniger geeignet als Positivresists, wie z.B. zur Abbildung von äquidistanten Linien bzw. Zwischenräumen oder Kontaktlöchern.

Chemisch verstärkte Positivphotoresists auf Basis speziell substituierter Polystyrole, die auch wiederkehrende Struktureinheiten der weiter unten genannten Formel (Ia) enthalten können, sind in der EP-A-0 476 865 beschrieben. Die dort verwendeten Polymere zeigen jedoch unter anderem einen zu niedrigen Glasübergangspunkt und ein schlechtes thermisches Fliessverhalten. Weiterhin kann es aufgrund der räumlichen Nähe von phenolischen OH-Gruppen und den Struktureinheiten der Formel (Ia) leicht zu einer vorzeitigen Spaltung der säurespaltbaren Gruppen an diesen Struktureinheiten kommen, z. B. schon während Applikation und Trocknung der Resistbeschichtung oder während einer Zwischenlagerung von resistbeschichtetem aber noch unbelichtetem Material, so dass ein Photoresist auf Basis dieser Polymere nur unter relativ engen Verfahrensbedingungen in vorteilhafter Weise einsetzbar ist. Dies ist unter anderem deshalb von Nachteil, da der eingeschränkte Prozessspielraum des Resists einen potentiellen Anwender dazu zwingen kann, eine bei ihm bereits eingeführte Verfahrensweise relativ stark zu verändern, um sie an den neuen Resist anzupassen.

Die vorliegende Erfindung betrifft Polymere, die wiederkehrende Struktureinheiten, ausgewählt aus den Struktureinheiten der Formeln (Ia) und (Ib)

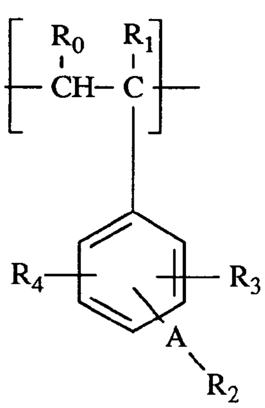

(Ia)

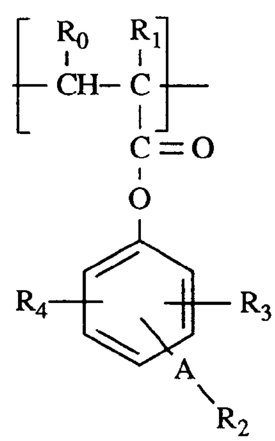

(Ib),

sowie ausser diesen Struktureinheiten wiederkehrende Struktureinheiten der Formel (II) enthalten

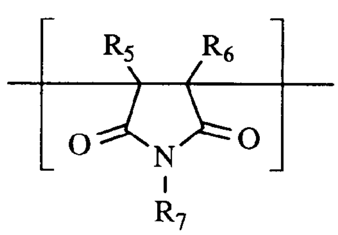

(II),

wobei

A eine direkte Einfachbindung oder eine zweiwertige Gruppe der Formel -O- bedeutet;

$R_0$ und

$R_1$ unabhängig voneinander jeweils ein Wasserstoffatom, eine $C_1$-$C_6$-Alkylgruppe oder eine Arylgruppe mit 6 bis 14 Ringkohlenstoffatomen darstellen;

$R_2$ einen Rest der Formel

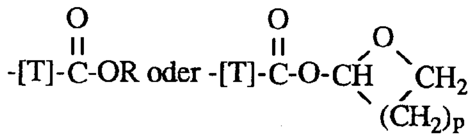

darstellt, worin

[T] für eine $C_1$-$C_6$-Alkylengruppe oder für eine Arylengruppe mit 6 bis 14 Ringkohlenstoffatomen,

R für einen tert.-Alkylrest mit 4 bis 19 Kohlenstoffatomen oder für eine Gruppe der Formel

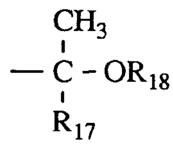 oder 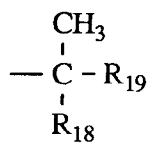

und

p für eine der Zahlen 2, 3 oder 4 stehen; oder A zusammen mit $R_2$ eine Gruppe der Formel

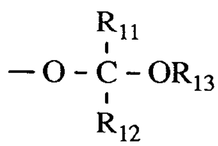

darstellt; und wobei weiterhin

$R_3$ und

$R_4$ unabhängig voneinander jeweils ein Wasserstoffatom, ein Halogenatom, eine $C_1$-$C_6$-Alkylgruppe oder eine $C_1$-$C_6$-Alkoxygruppe darstellen;

$R_5$ und

$R_6$ unabhängig voneinander jeweils ein Wasserstoffatom, eine $C_1$-$C_6$-Alkylgruppe oder eine Arylgruppe mit 6 bis 14 Ringkohlenstoffatomen darstellen und

$R_7$ ein Wasserstoffatom, eine Hydroxylgruppe, eine Trialkylsilylgruppe, eine $C_1$-$C_6$-Alkylgruppe, eine Arylgruppe mit 6 bis 14 Ringkohlenstoffatomen oder eine Gruppe der Formel -[G]-O-$R_8$ darstellt, worin

[G] für eine $C_1$-$C_6$-Alkylengruppe oder für eine Arylengruppe mit 6 bis 14 Ringkohlenstoffatomen und

$R_8$ für ein Wasserstoffatom, eine Trialkylsilylgruppe oder einen Rest der Formel

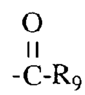

stehen, worin

$R_9$ ein Wasserstoffatom oder eine Methylgruppe bedeutet, oder $R_7$ eine Gruppe der Formel

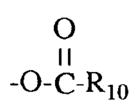

darstellt, worin

$R_{10}$ eine $C_1$-$C_6$-Alkylgruppe oder eine Arylgruppe mit 6 bis 14 Ringkohlenstoffatomen bedeutet;

$R_{11}$ sowie

$R_{12}$ unabhängig voneinander jeweils ein Wasserstoffatom, eine $C_1$-$C_6$-Alkylgruppe, eine Cycloalkylgruppe mit 3 bis 6 Ringkohlenstoffatomen oder eine Arylgruppe mit 6 bis 10 Ringkohlenstoffatomen bedeuten, wobei Arylgruppen entweder unsubstituiert sind oder einen oder mehrere Substituenten aufweisen, ausgewählt aus Halogenatomen, insbesondere Cl oder Br, $C_1$-$C_4$-Alkyl- und $C_1$-$C_4$-Alkoxygruppen sowie -CN und -$NO_2$;

$R_{13}$ eine $C_1$-$C_6$-Alkylgruppe, eine Cycloalkylgruppe mit 3 bis 6 Ringkohlenstoffatomen oder eine Arylgruppe mit 6 bis 10 Ringkohlenstoffatomen bedeutet, wobei Arylgruppen entweder unsubstituiert sind oder einen oder mehrere Substituenten aufweisen, ausgewählt aus Halogenatomen, insbesondere Cl oder Br, $C_1$-$C_4$-Alkyl- und $C_1$-$C_4$-Alkoxygruppen sowie -CN und -$NO_2$; und

$R_{17}$ ein Wasserstoffatom oder eine $C_1$-$C_4$-Alkylgruppe;

$R_{18}$ eine $C_1$-$C_6$-Alkylgruppe oder eine $C_3$-$C_6$-Cycloalkylgruppe sowie

$R_{19}$ eine Arylgruppe mit 6 bis 14 Ringkohlenstoffatomen bedeuten.

Die erfindungsgemässen Polymere weisen die oben geschilderten Nachteile der bisher für chemisch verstärkte Positivphotoresists verwendeten Polymere nicht auf. Die Positivphotoresists auf Basis dieser Polymere zeigen zudem besonders grosse Löslichkeitsunterschiede zwischen bestrahltem und unbestrahltem Material und somit ein ausgezeichnetes Kontrastverhalten. Chemisch verstärkte Positivresists auf Basis der erfindungsgemässen Polymere führen weiterhin aufgrund der vergleichsweise geringen Schrumpfungstendenz der bestrahlten Partien zu sehr massgenauen und reproduzierbaren Reliefstrukturen. Die Resists zeigen weiterhin kaum delay time-Effekte, d. h. sie ergeben z. B. auch bei längeren Zeitperioden zwischen der Bestrahlung und der bei chemisch verstärkten Resists meist erforderlichen thermischen Nachbehandlung maskengetreue Reliefstrukturen mit senkrechten Wänden und neigen in diesen Fällen auch bei Abbildung von Strukturen im Submikrobereich nicht zur Ausbildung von T-förmigen Profilen, wie es üblicherweise die Resists des Standes der Technik tun. Die erwähnten "T-tops" an den abgebildeten Profilen sind wahrscheinlich eine Folge flüchtiger Basen in der Umgebungsatmosphäre, die bevorzugt vom oberen Bereich der belichteten Resistpartien absorbiert werden, und können bisher nur mit Hilfe spezieller Schutzbeschichtungen, aufwendiger Luftfilterung, speziellen Entwicklern oder durch Zusatz bestimmter Additive zu den Resistzusammensetzungen vermieden werden, wie es z. B. D.J.H. Funhoff, H. Binder und R. Schwalm in "Deep-UV Resists with improved delay capacities", SPIE Vol. 1672 (Adv. Resist Technol. Process.), 46-55 (1992) beschreiben. Alle diese Massnahmen weisen jedoch bestimmte Nachteile auf, vermindern beispielsweise die Empfindlichkeit der Photoresists in unvorteilhafter Weise.

Bei den erfindungsgemässen Polymeren können durch $R_0$, $R_1$, $R_5$, $R_6$, $R_7$, $R_{10}$, $R_{11}$, $R_{12}$, $R_{13}$, $R_{17}$ oder $R_{18}$ dargestellte Alkylgruppen beziehungsweise durch $R_3$ oder $R_4$ dargestellte Alkyl- oder Alkoxygruppen geradkettig oder verzweigt sein. Als Beispiele seien genannt: Methyl, Ethyl, n-Propyl, i-Propyl, n-Butyl, sec.-Butyl, tert.-Butyl, n-Pentyl, neo-Pentyl, n-Hexyl, Methoxy, Ethoxy, n-Propoxy, i-Propoxy, n-Butoxy, sec.-Butoxy, tert.-Butoxy, n-Pentoxy, neo-Pentoxy und n-Hexoxy.

Durch $R_6$, $R_1$, $R_5$, $R_6$, $R_7$, $R_{10}$ oder $R_{19}$ dargestellte Arylgruppen mit 6 bis 14 Ringkohlenstoffatomen können unsubstituiert sein oder einen oder mehrere Substituenten aufweisen, z. B. $C_1$-$C_6$-Alkyl-, $C_1$-$C_6$-Alkoxy- oder Halogensubstituenten, insbesondere Cl oder Br. Beispiele für geeignete Arylgruppen sind Phenyl, Tolyl, Xylyl, Mesityl, Naphthyl, Anthryl, Phenanthryl, Fluorenyl, Biphenyl. Bevorzugt sind jeweils Arylgruppen mit 6 bis 10 Ringkohlenstoffatomen, insbesondere Phenyl und Naphthyl.

$R_{11}$, $R_{12}$ und $R_{13}$ in der Bedeutung Aryl sind ebenfalls bevorzugt Phenyl- oder Naphthylgruppen.

Halogenatome als Reste $R_3$ oder $R_4$ sind vorzugsweise Brom- oder Chloratome.

R in der Bedeutung tert.-Alkyl mit 4 bis 19 Kohlenstoffatomen stellt bevorzugt eine Gruppe der Formel

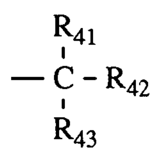 ,

worin die Reste $R_{41}$, $R_{42}$ und $R_{43}$ gleiche oder verschiedene unverzweigte Alkylgruppen mit 1 bis 6, bevorzugt mit 1 bis 4 Kohlenstoffatomen darstellen. Ganz besonders bevorzugte Reste R sind tert.-Pentyl und insbesondere tert.-Butyl.

Bedeuten $R_7$ oder $R_8$ eine Trialkylsilylgruppe, so stellt diese bevorzugt eine Gruppe der Formel

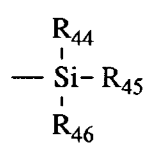 ,

worin die Reste $R_{44}$, $R_{45}$ und $R_{46}$ gleiche oder verschiedene unverzweigte Alkylgruppen mit 1 bis 6, bevorzugt mit 1 bis 4 Kohlenstoffatomen darstellen. Ganz besonders bevorzugt als Trialkylsilyl ist in beiden Fällen Trimethylsilyl.

Durch [T] und [G] dargestellte $C_1$-$C_6$-Alkylengruppen können ebenfalls geradkettig oder verzweigt sein.

Beispiele dafür sind Methylen, Ethylen, Propylen, 2,2-Propandiyl, Trimethylen, Tetramethylen und Hexamethylen.

Durch [T] und [G] dargestellte Arylengruppen mit 6 bis 14 Ringkohlenstoffatomen können sonst unsubstituiert sein oder einen oder mehrere Substituenten aufweisen, z. B. $C_1$-$C_6$-Alkyl-, $C_1$-$C_6$-Alkoxy- oder Halogensubstituenten. Beispiele für geeignete Arylgruppen sind m-Phenylen, p-Phenylen, Tolylen, z. B. 2,5-Tolylen, Xylylen, Naphthylen oder 4,4'-Biphenylen. Bevorzugt sind jeweils Arylengruppen mit 6 bis 10 Ringkohlenstoffatomen, insbesondere Phenylen und Naphthylen.

Erfindungsgemässe Polymere mit Struktureinheiten der Formel (Ia) und/oder der Formel (Ib), die Reste der Formel

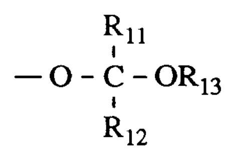

oder insbesondere der Formel

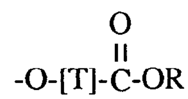

oder

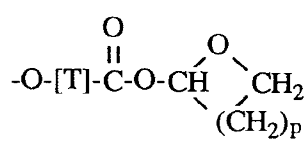

aufweisen, wobei die übrigen Symbole die oben bereits genannte Bedeutung haben, sind besonders bevorzugt.

Neben den wiederkehrenden Struktureinheiten der oben genannten Formeln (Ia), (Ib) und (II) können die Polymere noch andere Struktureinheiten in ihrem Polymerengerüst enthalten, die aus einem Monomer mit einer polymerisierbaren Doppelbindung bei Polymerisation über diese Doppelbindung erhältlich sind. Diese anderen Struktureinheiten können im allgemeinen bis zu 50 mol% der wiederkehrenden Struktureinheiten der Polymere ausmachen. Sollen die erfindungsgemässen Polymere als eine Polymerkomponente eines chemisch verstärkten Positivphotoresists eingesetzt werden, ist es aber wichtig, dass die Polymere nur soviel von den zusätzlichen Struktureinheiten enthalten, dass der auf ihnen basierende Resist im unbestrahlten Zustand in den als Entwickler üblicherweise verwendeten wässerig-alkalischen Lösungen unlöslich ist, sich in bestrahltem Zustand jedoch einwandfrei löst. Selbstverständlich kann dies je nach Art der Struktureinheiten unterschiedlich sein, die Eignung eines zusätzlich andere Struktureinheiten aufweisenden Polymers kann jedoch leicht experimentell überprüft werden. Als Beispiel für Polymere dieses Typs seien Polymere genannt, die neben den Struktureinheiten der Formeln (Ia) und/oder (Ib) sowie (II) noch wiederkehrende Struktureinheiten der Formel (III) enthalten

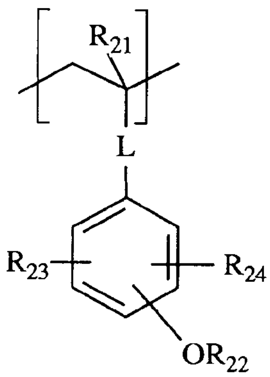

(III),

worin

$R_{21}$ Wasserstoff oder Methyl bedeutet;

L für eine direkte Bindung oder einen zweiwertigen Rest der Formel

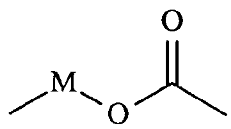

steht, worin

M eine an den Phenylkern gebundene $C_1$-$C_6$-Alkylengruppe bedeutet,

$OR_{22}$ einen säurespaltbaren Rest darstellt, worin

$R_{22}$ $C_4$-$C_{10}$-tert.-Alkyl, unsubstituiertes oder durch eine oder mehrere $C_1$-$C_6$-Alkylgruppen, $C_1$-$C_6$-Alkoxygruppen oder Halogenatome substituiertes Allyl, Cyclohex-2-enyl, $C_6$-$C_{14}$-Aryl oder $C_7$-$C_{16}$-Aralkyl, Trialkylsilyl, oder eine Gruppe der folgenden Formeln darstellt

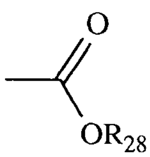

,

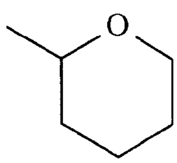

,

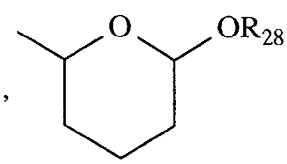

,

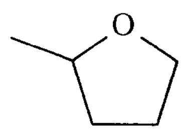

,

worin

$R_{28}$ $C_1$-$C_6$-Alkyl oder unsubstituiertes oder durch eine oder mehrere $C_1$-$C_6$-Alkylgruppen, $C_1$-$C_6$-Alkoxygruppen oder Halogenatome substituiertes $C_6$-$C_{14}$-Aryl oder $C_7$-$C_{16}$-Aralkyl bedeutet sowie

$R_{23}$ und

$R_{24}$ unabhängig voneinander für Wasserstoff, $C_1$-$C_6$-Alkylgruppen, $C_1$-$C_6$-Alkoxygruppen oder Halogenatome stehen.

Bevorzugt sind jedoch erfindungsgemässe Polymere, die nur wiederkehrende Strukturelemente der Formeln (Ia), (Ib) und (II) aufweisen, ganz besonders Polymere bestehend aus wiederkehrenden Strukturelementen der Formel (Ia) sowie der Formel (II). Besonders bevorzugt sind diejenigen dieser Polymere, bei denen

A die Gruppe -O- bedeutet;

$R_0$ ein Wasserstoffatom und

$R_1$ ein Wasserstoffatom oder eine $C_1$-$C_6$-Alkylgruppe darstellen;

$R_2$ einen Rest der Formel

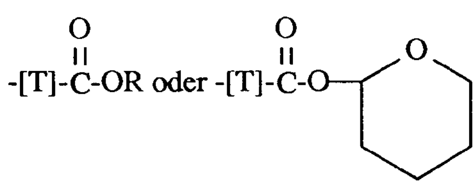

darstellt, worin

R für einen tert.-Alkylrest mit 4 bis 19, insbesondere 4 bis 10 Kohlenstoffatomen und

[T] für eine $C_1$-$C_6$-Alkylengruppe stehen;

$R_3$ und

$R_4$ sowie

$R_5$ und

$R_6$ unabhängig voneinanander jeweils ein Wasserstoffatom oder eine $C_1$-$C_6$-Alkylgruppe darstellen; und

$R_7$ ein Wasserstoffatom, eine Hydroxylgruppe, eine $C_1$-$C_6$-Alkylgruppe, eine Arylgruppe mit 6 bis 10 Ringkohlenstoffatomen oder eine Gruppe der Formel -[G]-O-$R_8$ darstellt, worin

[G] für eine $C_1$-$C_6$-Alkylengruppe oder für eine Arylengruppe mit 6 Ringkohlenstoffatomen und

$R_8$ für ein Wasserstoffatom, eine Trimethylsilylgruppe oder den Rest

$$-O-\overset{\overset{O}{\|}}{C}-CH_3$$

stehen, insbesondere die der zuletzt genannten Polymere, bei denen

$R_1$ ein Wasserstoffatom;

$R_2$ einen Rest der Formel

$$-CH_2\overset{\overset{O}{\|}}{C}-OC(CH_3)_3$$

$R_3$ und

$R_4$ sowie

$R_5$ und

$R_6$ ein Wasserstoffatom und

$R_7$ ein Wasserstoffatom, eine $C_1$-$C_6$-Alkylgruppe, eine Phenylgruppe, $-CH_2OH$ oder

$$-CH_2-O-\overset{\overset{O}{\|}}{C}-CH_3$$

darstellen.

Die erfindungsgemässen Polymere weisen zweckmässigerweise ein Molekulargewicht (Gewichtsmittel) $M_w$ von 1000 bis 1000000, gemessen mittels Gelpermeationschromatographie, vorzugsweise von 5000 bis 500000 auf. Besonders vorteilhaft erweist sich meist ein Molekulargewicht von 10000 bis 100000, z. B. etwa 20000.

Zweckmässigerweise liegt weiterhin das Zahlenverhältnis von Struktureinheiten der Formel (Ia) und (Ib) zu Struktureinheiten der Formel (II) im Molekül erfindungsgemässer Polymere durchschnittlich zwischen 5:1 und 1:1. Abgesehen von Polymeren, die mit einem Überschuss an Styrolmonomer hergestellt werden, wechseln sich im allgemeinen Maleinimid- und Styrolstruktureinheiten im Polymerengerüst ab. Die Verwendung eines Überschusses an Maleinimidmonomeren bezogen auf eingesetztes Styrolmonomer sollte vermieden werden, da der Maleinimidüberschuss im allgemeinen nicht mehr reagiert.

Ein erfindungsgemässes Polymer mit besonders günstigen Eigenschaften ist beispielsweise aus N-(Acetoxymethyl)maleinimid und N-Hydroxymethylmaleinimid als Maleinimidmonomeren aufgebaut.

Die erfindungsgemässen Polymere können auf bekannte Weise durch radikalische Copolymerisation von Verbindungen der Formel ($M_{Ia}$) und/oder Verbindungen der Formel ($M_{Ib}$)

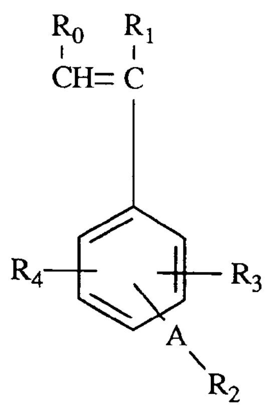 $(M_{Ia})$, 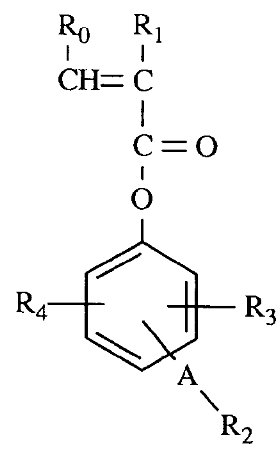 $(M_{Ib})$

zusammen mit Verbindungen der Formel $(M_{II})$

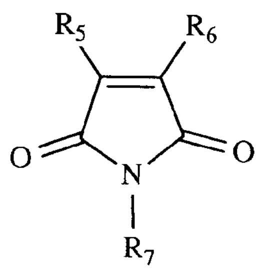 $(M_{II})$

und gegebenenfalls weiteren Monomeren mit polymerisierbarer Doppelbindung hergestellt werden. In den genannten Formels haben $R_0$ bis $R_7$ und A jeweils die oben schon angegebene Bedeutung.

Die radikalische Copolymerisation kann unter Anwendung verschiedener Techniken sowohl thermisch als auch strahlungsinduziert durchgeführt werden. Geeignete Polymerisationsreaktionen sind beispielsweise in S. Sandler und W. Karo "Polymer Synthesis", Vol. 1, S. 3-17, 1968, Academic Press, New York, beschrieben. Übliche Polymerisationsverfahren sind beispielsweise die Polymerisation in der Masse oder in Lösungsmitteln, ferner die Emulsions-, Suspension- oder Fällungspolymensation.

Die Ausgangsprodukte der Formeln $(M_{Ia})$, $(M_{Ib})$ und $(M_{II})$ sind teilweise bekannt und können nach bekannten Methoden oder analog hierzu hergestellt werden.

Die Verbindungen der Formel $(M_{Ia})$, worin A eine Sauerstoffbrücke bedeutet, können z. B. in der in der EP-A-0 476 865 beschriebenen Weise durch Umsetzung eines entsprechenden Hydroxystyrolmonomeren mit einer Verbindung der Formel $R_2$(Hal) in Gegenwart einer Base erhalten werden, wobei $R_2$ wieder die oben schon genannte Bedeutung hat und Hal ein Chlor oder Bromatom bedeutet. Die Verbindungen der Formel $(M_{Ib})$, worin A eine Sauerstoffbrücke bedeutet, können unter anderem in ebenfalls bekannter Weise durch Veresterung des gewünschten (Meth)acrylsäurederivats der Formel $R_0$-CH=C($R_1$)-COOH mit Phenolen der Formel

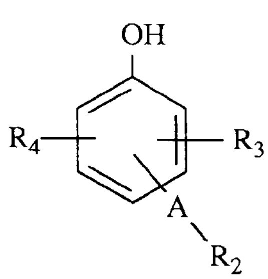

hergestellt werden, wobei die Phenole z. B. analog zu der oben geschilderten Herstellungsweise für Verbindungen der Formel $(M_{Ia})$ erhältlich sind.

Bedeutet A in Formel $(M_{Ia})$ eine direkte Bindung, so sind die entsprechenden Monomeren unter anderem auf folgende Weise erhältlich, wobei weiter oben bereits verwendete Formelsymbole jeweils die dort schon genannte Bedeutung haben:

Man geht aus von einer Verbindung der Formel

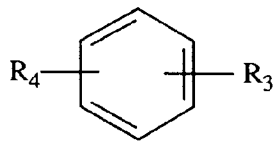

und setzt diese unter Friedel-Crafts-Bedingungen in Gegenwart z. B. von $AlCl_3$ mit einem Lacton der Formel

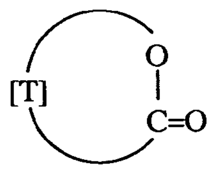

analog der Vorschrift von R. V. Christian jr., J. Am. Chem. Soc. 74 (1952), Seiten 1591 und 1592 zu einem Produkt der Formel

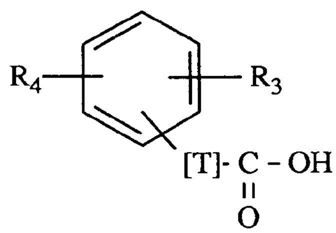

um. Dieses wird dann z. B. entweder mit einem Alkohol der Formel R-OH verestert oder mit einer Verbindung der Formel

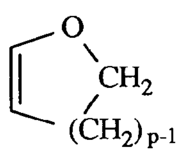

in saurer Lösung umgesetzt, je nachdem ob $R_2$ in Formel ($M_{Ia}$) ein Rest der Formel

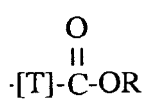

oder

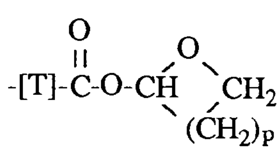

sein soll. Danach wird das Produkt nach einer üblichen Weise am Phenylkern bromiert und die hierbei erhaltene Verbindung der Formel

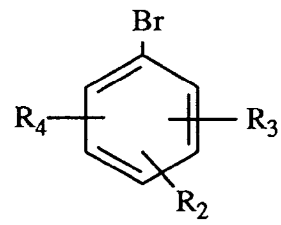

in ebenfalls bekannter Weise mit einer Alkenverbindung der Formel $R_0$-CH=CH-$R_1$ in Gegenwart eines geeigneten Palladium(0)-Katalysators und einer Base zum Monomer der Formel ($M_{Ia}$) weiterverarbeitet, wie dies beispielsweise in COMPREHENSIVE ORGANIC SYNTHESIS, Vol. 4, 1. Ausgabe 1991, Pergamon Press, Oxford·New York·Seoul·Tokyo, S. 843-848 beschrieben ist.

Bedeutet A in Formel ($M_{Ib}$) eine direkte Bindung, so sind die entsprechenden Monomeren z. B. ausgehend von einer Verbindung der Formel

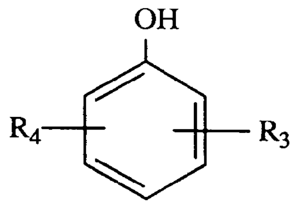

durch Umsetzung mit dem entsprechenden Lacton sowie einem Alkohol der Formel R-OH beziehungsweise einer Verbindung der Formel

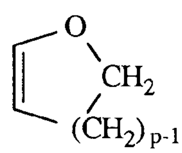

analog der oben geschilderten Verfahrensweise und anschliessende Umsetzung des hierbei erhaltenen Produkts mit dem gewünschten (Meth)acrylsäurederivat der Formel $R_0$-CH=C($R_1$)-COOH erhältlich.

Darstellungsverfahren für Monomere der Formeln $M_{Ia}$ und $M_{Ib}$, bei denen A zusammen mit $R_2$ eine Gruppe der Formel

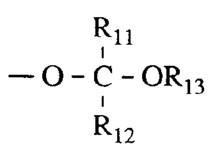

darstellt, sind dem Fachmann ebenfalls bekannt. Eine Vielzahl verschiedener allgemein anwendbarer Verfahren sind beispielsweise in Houben-Weyl "Methoden der organischen Chemie", Bd. E14a/1 (O/O- und O/S-Acetale); Georg Thieme Verlag Stuttgart·New York (1991), S. 1 bis 591 beschrieben. Beispielsweise können Halogen/$OR_{13}$-Acetale mit den phenolischen Vorläufern der Monomere $M_{Ia}$ oder $M_{Ib}$ in Gegenwart von Hilfsbasen, wie tertiären Aminen, umgesetzt werden (S. 19 ff. des genannten Bandes von Houben-Weyl). Eine weitere sehr günstige Methode ist die Addition von Ethern mit dem Strukturelement

$$>C=C<^{OR_{13}} ,$$

insbesondere von 2-Methoxypropen oder von entsprechenden Vinylethern, wie z. B. tert.-Butylvinylether, an phenolische Vorläufer der Monomere $M_{Ia}$ oder $M_{Ib}$ in Gegenwart von Säuren, wie z. B. p-Toluolsulfonsäure.

Beispiele für geeignete Monomere der Formel ($M_{Ia}$) sind 2-(4-Vinylphenoxy)-2-methoxypropan, 1-(4-Vinylphenoxy)-1-tert.-butoxyethan, (4-Vinylphenoxy)-essigsäure-tert.-butylester, der entsprechende tert.-Pentylester; die tert.-Butylester und tert.-Pentylester von (4-Vinylphenoxy)-propionsäure und von (4-Vinylphenoxy)-buttersäure sowie die (4-Vinylphenoxy)-essigsäureester, die (4-Vinylphenoxy)-propionsäureester und die (4-Vinylphenoxy)-buttersäureester von 2-Tetrahydrofuranol und 2-Tetrahydropyranol. Beispiele für Monomere der Formel ($M_{Ib}$) sind die Acrylsäure- und Methacrylsäureester von 4-(tert.-Butylcarbonylmethyl)-phenol und von 4-(2-(tert -Butylcarbonyl)-ethyl)-phenol.

Die Verbindungen der Formel ($M_{II}$) sind ebenfalls bekannt oder können nach bekannten Verfahren aus Maleinimid bzw. den entsprechenden, die gewünschten $R_5$- und/oder $R_6$-Substituenten aufweisenden Maleinimidderivaten hergestellt werden, beispielsweise indem das Maleinimid mit einem Halogenid oder einem Tosylat der Formel LG-$R_7$, worin $R_7$ die oben schon angegebene Bedeutung hat und LG für Halogen oder $CH_3$-$C_6H_4$-$SO_3$- steht, in Gegenwart von Basen umgesetzt wird.

Die Synthese von N-Hydroxymethylmaleinimid aus Maleinimid und Formaldehyd in Gegenwart von NaOH ist beispielsweise in der EP-A 410 794 beschrieben.

Geeignete Verbindungen der Formeln ($M_{II}$) sind unter anderem N-Hydroxymethylmaleinimid, N-2-Hydroxyethylmaleinimid, N-3-Hydroxypropylmaleinimid, N-4-Hydroxybutylmaleinimid, N-(2-Hydroxyprop-2-yl)maleinimid, N-Methoxymethylmaleinimid, N-Phenoxymethylmaleinimid, N-Benzyloxymethylmaleinimid, N-2-Methoxyethylmaleinimid, N-3-Methoxypropylmaleinimid, N-4-Methoxybutylmaleinimid, N-Acetoxymethylmaleinimid und N-(2-Acetoxyethyl)maleinimid.

Beispiele für weitere Comonomere mit polymerisierbaren Doppelbindungen, die zur Herstellung erfindungsgemässer Polymere durch Copolymerisation mit den Monomeren der Formeln ($M_{Ia}$), ($M_{Ib}$) und ($M_{II}$) geeignet sind, sind 4-Tert.-butoxystyrol, 4-Phenoxystyrol, 4-Benzyloxystyrol, 4-Trimethylsilyloxystyrol, 4-Allyloxystyrol, 4-Methallyloxystyrol, 4-(Tert.-butoxycarbonyloxy)styrol, 4-(2-Tetrahydropyranyloxy)styrol, 4-(2-Tetrahydrofuranyloxy)styrol, 4-(3-Methylbut-2-enyloxy)styrol, Methacrylsäure-4-(2-tetrahydropyranyloxy) benzylester und Acrylsäure-4-(2-tetrahydropyranyloxy)benzylester.

Die Polymerisation wird in der Regel durch einen üblichen Radikalstarter initiert. Dazu zählen thermische Initiatoren, wie Azoverbindungen, beispielsweise $\alpha,\alpha'$-Azoisobutyronitril (AIBN), oder Peroxide, beispielsweise Benzoylperoxid, oder Redoxinitiatorsysteme, wie eine Mischung von Eisen(III)acetyl-acetonat, Benzoin und Benzoylperoxid, oder photochemische Radikalbildner, wie Benzoin oder Benzildimethylketal.

Die Polymerisation wird bevorzugt in Lösung durchgeführt. Die Reaktionstemperatur bewegt sich im allgemeinen im Bereich von 10 bis 200°C, vorzugsweise zwischen 40 und 150°C, besonders bevorzugt zwischen 40 und 100°C.

Gegebenenfalls anwesende Lösungsmittel müssen unter den Reaktionsbedingungen inert sein. Als Lösungsmittel kommen u.a. aromatische Kohlenwasserstoffe, chlorierte Kohlenwasserstoffe, Ketone und Ether in Betracht. Beispiele hierfür sind: Benzol, Toluol, Xylole, Ethylbenzol, Isopropylbenzol, Ethylenchlorid, Propylenchlorid, Methylenchlorid, Chloroform, Methylethylketon, Aceton, Cyclohexanon, Diethylether Diglyme oder Tetrahydrofuran.

Die Erfindung betrifft weiterhin auch strahlungsempfindliche Zusammensetzungen enthaltend

a) mindestens ein erfindungsgemässes Polymer wie oben definiert und

b) mindestens eine unter der Einwirkung von aktinischer Strahlung säurebildende Verbindung.

Diese Zusammensetzungen können in vorteilhafter Weise z. B. als chemisch verstärkter Positivphotoresist eingesetzt werden.

Die erfindungsgemässen Zusammensetzungen können als eine weitere Komponente c) ein Lösungsmittel oder ein Lösungsmittelgemisch enthalten.

Weiterhin können die erfindungsgemässen Zusammensetzungen Lösungsinhibitoren enthalten, die die Löslichkeit der Zusammensetzung in üblichen alkalischen Entwicklern herabsetzen, die aber unter der Einwirkung von Säure in der Weise gespalten werden, dass die verbleibenden Reaktionsprodukte im Entwickler löslich sind. Solche Lösungsinhibitoren sind dem Fachmann bekannt und beispielsweise in der EP-A 329 610, der EP-A 541 112 und der EP-A 475 903 beschrieben.

Als Verbindungen b), die unter der Einwirkung von aktinischer Strahlung Säure bilden, kommen insbesondere Oniumsalze, wie Diazonium-, Sulfonium-, Sulfoxonium- und Iodoniumsalze sowie Disulfone in Betracht. Bevorzugt sind Sulfoniumsalze der Formel (IV)

$$(Ar_1)_q(Z_1)_r(Z_2)_sS^{\oplus}\,X_1^{\ominus} \qquad \text{(IV)},$$

worin

- $Ar_1$ unsubstituiertes oder durch Halogen, $C_1$-$C_4$-Alkyl, $C_1$-$C_4$-Alkoxy, -OH und/oder nitro-substituiertes Phenyl, Naphthyl oder Phenyl-$COCH_2$- ist,
- $Z_1$ $C_1$-$C_6$-Alkyl oder $C_3$-$C_7$-Cycloalkyl und
- $Z_2$ Tetrahydrothienyl, Tetrahydrofuryl oder Hexahydropyryl sind,
- q für 0, 1, 2 oder 3,
- r für 0, 1 oder 2 und
- s für 0 oder 1 stehen, wobei die Summe q+r+s 3 beträgt, und

$X_1^{\ominus}$ ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

Phenyl-, Naphthyl- und Phenacylgruppen $Ar_1$ sind bevorzugt einfach substituiert, insbesondere durch Cl, Br, Methyl, Methoxy, -OH oder Nitro. Besonders bevorzugt sind diese Reste unsubstituiert. $Z_1$ ist vorzugsweise $C_1$-$C_4$-Alkyl, insbesondere Methyl oder Ethyl. Bevorzugt sind q 2 oder 3, r 1 oder Null und s Null, insbesondere ist q die Zahl 3 und r und s sind Null. Ganz besonders bevorzugt ist $Ar_1$ unsubstituiertes Phenyl und q ist 3.

Stellt $X_1^{\ominus}$ das Anion einer organischen Sulfonsäure oder Carbonsäure dar, so kann es sich um Anionen von aliphatischen, cycloaliphatischen, carbocyclisch-aromatischen, heterocyclisch-aromatischen oder araliphatischen Sulfon- oder Carbonsäuren handeln. Diese Anionen können substituiert oder unsubstituiert sein. Bevorzugt sind Sulfon- und Carbonsäure mit geringer Nucleophilie, beispielsweise teil- oder perfluorierte Derivate oder in Nachbarstellung zur jeweiligen Säuregruppe substituierte Derivate. Beispiele für Substituenten sind Halogen, wie Chlor oder besonder Fluor, Alkyl, wie Methyl, Ethyl oder n-Propyl, oder Alkoxy, wie Methoxy, Ethoxy oder n-Propoxy.

Beispiele für aliphatische Sulfonsäuren sind Methan-, Ethan-, n-Propan-, n-Butan- und n-Hexansulfonsäure oder die entsprechenden teil- oder perfluorierten Derivate.

Beispiele für aliphatische Carbonsäuren sind Ameisensäure, Essigsäure, Propionsäure, Buttersäure, Pivalinsäure, Capronsäure, 2-Ethylhexylcarbonsäure und Fettsäuren, wie Laurinsäure, Myristinsäure oder Stearinsäure, sowie die teil- oder perfluorierten Derivate dieser Säuren.

Beispiele für cycloaliphatische Sulfon- oder Carbonsäuren sind Cyclohexansulfonsäure, Cyclohexancarbonsäure, Campher-10-sulfonsäure oder deren teil- oder perfluorierte Derivate.

Beispiele für carbocyclisch-aromatische Sulfonsäuren sind Benzol-, Toluol-, Ethylbenzol-, Isopropylbenzol-, Dodecylbenzol- oder Dimethylbenzolsulfonsäure, 2,4,6-Triisopropylbenzolsulfonsäure, 2,4,6-Trimethylbenzolsulfonsäure, Naphthalin-mono-, -di- oder -tri-sulfonsäuren und die entsprechenden alkylierten oder teil- oder perfluorierten Derivate dieser Sulfonsäuren.

Beispiele für heterocyclisch-aromatische Sulfonsäuren sind Pyridin-, Thiophen- oder Pyrrolsulfonsäure und die entsprechenden teil- oder perfluorierten Derivate dieser Säuren.

Beispiele für araliphatische Sulfonsäuren sind Benzylsulfonsäure, α-Methylbenzylsulfonsäure und die entsprechenden teil- oder perfluorierten Derivate dieser Verbindungen.

Beispiele für carbocyclisch-aromatische Carbonsäuren sind Benzoesäure, Toluol-, Ethylbenzol-, Isopropylbenzol- oder Dimethylbenzolcarbonsäure, Naphthalincarbonsäure oder Anthracencarbonsäure und die entsprechenden teil- oder perfluorierten Derivate dieser Verbindungen.

Beispiele für heterocyclisch-aromatische Carbonsäuren sind Pyridin-, Thiophen- oder Pyrrolcarbonsäure sowie die entsprechenden teil- oder perfluorierten Derivate dieser Verbindungen.

Beispiele für araliphatische Carbonsäuren sind Benzylcarbonsäure, α-Methylbenzylcarbonsäure und Zimtsäure, sowie die entsprechenden teil- oder perfluorierten Derivate dieser Verbindungen.

Vorzugsweise handelt es sich bei $X_1^{\ominus}$ um das einwertige Anion einer organischen Sulfonsäure, insbesondere einer Teilfluor- oder Perfluorsulfonsäure. Diese Anionen zeichnen sich durch eine besonders geringe Nucleophilie aus.

Spezielle Beispiele für geeignete Sulfoniumsalze der Formel (IV) sind Triphenylsulfoniumbromid, Triphenylsulfoniumchlorid, Triphenylsulfoniumiodid, Triphenylsulfoniumhexafluorphosphat, Triphenylsulfoniumhexafluorantimonat, Triphenylsulfoniumhexafluorarsenat, Triphenylsulfoniumtrifluormethansulfonat, Diphenylethylsulfoniumchlorid, Phenacyldimethylsulfoniumchlorid, Phenacyltetrahydrothiopheniumchlorid, 4-Nitrophenacyltetrahydrothiopheniumchlorid und 4-Hydroxy-2-methylphenylhexahydrothiopyryliumchlorid. Besonders bevorzugt ist Triphenylsulfoniumtrifluormethansulfonat.

Als Verbindungen b) können auch Iodoniumsalze der Formel (V)

$$[Ar_2\text{-}I^{\oplus}\text{-}Ar_3]\ X_2^{\ominus} \qquad (V)$$

verwendet werden, worin

$Ar_2$ und $Ar_3$ unabhängig voneinander unsubstituiertes oder durch $C_1$-$C_4$-Alkyl, $C_1$-$C_4$-Alkoxy, Halogen und/oder nitro-substituiertes Phenyl oder Naphthyl sind oder $Ar_2$ und $Ar_3$ zusammen eine Gruppe der Formel (VI)

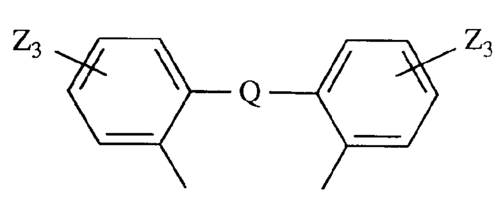

(VI)

darstellen, worin

$Z_3$ $C_1$-$C_4$-Alkyl, $C_1$-$C_4$-Alkoxy, Halogen oder Nitro und Q eine Direktbindung, -O-, -$CH_2$- oder -CO- darstellen und

$X_2^{\ominus}$ die gleiche Bedeutung wie $X_1^{\ominus}$ in der Formel (IV) hat.

Die Iodoniumsalze der Formel (V) sind z.B. in der GB-A 1 539 192 beschrieben.

Als Verbindungen b) eignen sich auch unter Einwirkung von aktinischer Strahlung Sulfonsäure erzeugende Substanzen der Formeln (VII) bis (XVI)

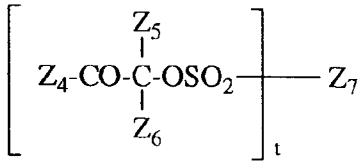

(VII),

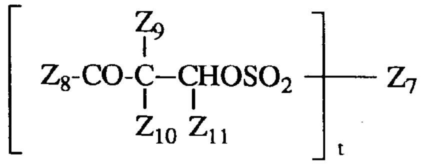

(VIII),

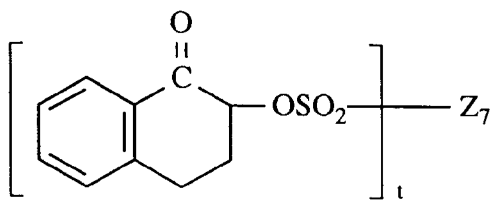

(IX),

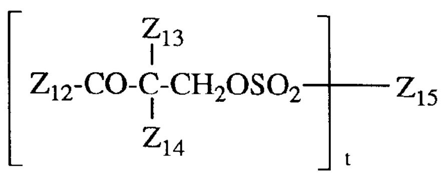

(X),

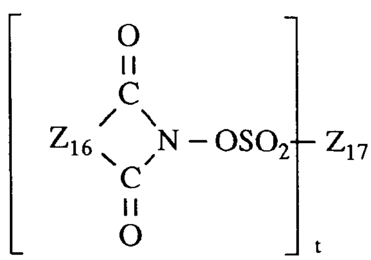

(XI)

$[Z_{18}CON(Z_{14})\text{-}OSO_2 ]_t\, Z_{17}$ (XII),

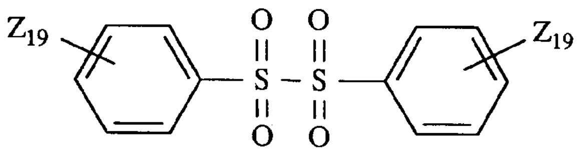

(XIII),

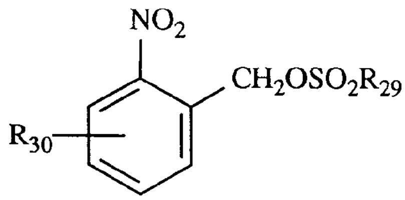

(XIV),

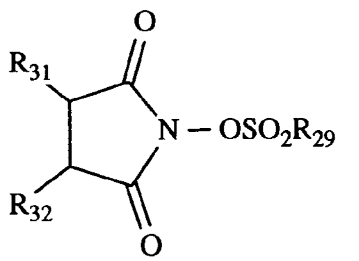

(XV)

und

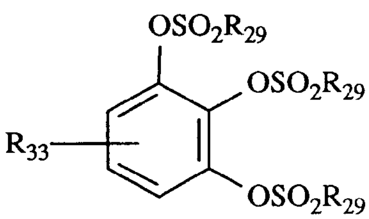

(XVI),

worin

t 1 oder 2, bevorzugt 1 ist,

$Z_4$ unsubstituiertes oder durch 1-3 -Cl, -Br, -CN, $-NO_2$, $C_1$-$C_4$-Alkyl, $C_1$-$C_4$-Alkoxy, $C_1$-$C_4$-Alkylthio, Phenoxy, Phenylthio, $C_1$-$C_4$-Alkylamino, $C_2$-$C_4$-Dialkylamino oder benzoylsubstituiertes Phenyl oder Naphthyl, besonders unsubstituiertes oder einfach durch -Cl, Methyl oder Methoxy substituiertes Phenyl darstellt,

$Z_5$ Wasserstoff oder $C_1$-$C_4$-Alkyl und

$Z_6$ Wasserstoff, $C_1$-$C_4$-Alkyl oder Phenyl bedeuten oder

$Z_5$ und

$Z_6$ zusammen mit dem Bindungs-C-Atom einen Cyclopentan- oder Cyclohexanring bilden,

$Z_7$ bei t = 1 $C_1$-$C_{18}$-Alkyl, unsubstituiertes oder durch $C_1$-$C_4$-Alkyl substituiertes Phenyl oder Naphthyl, Cyclopentyl, Cyclohexyl oder Campheryl und bei t = 2 $C_2$-$C_8$-Alkylen oder Phenylen bedeutet,

$Z_8$ unsubstituiertes oder durch 1-3 -Cl, -Br, $C_1$-$C_4$-Alkyl, $C_1$-$C_4$-Alkoxy, $C_1$-$C_4$-Alkylthio, Phenyl, Phenoxy, Phenylthio, $C_1$-$C_4$-Alkyl-CONH-, Benzoylamino, Dimethylamino substituiertes Phenyl oder Naphthyl, besonders unsubstituiertes oder einfach durch -Cl, $C_1$-$C_4$-Alkoxy, Methylthio oder Phenyl substituiertes Phenyl ist,

$Z_9$ -OH oder $C_1$-$C_4$-Alkyl ist,

$Z_{10}$ $C_1$-$C_4$-Alkyl oder Phenyl ist,

$Z_{11}$ Wasserstoff, $C_1$-$C_4$-Alkyl, Furyl oder $-CCl_3$ bedeutet oder

$Z_{10}$ und

$Z_{11}$ zusammen mit dem Bindungs-C-Atom einen Cyclopentan- oder Cyclohexanring bilden,

$Z_{12}$ und
$Z_{13}$ unabhängig voneinander unsubstituiertes oder durch Halogen, $C_1$-$C_4$-Alkyl oder $C_1$-$C_4$-Alkoxy substituiertes Phenyl sind,
$Z_{14}$ Wasserstoff oder $C_1$-$C_4$-Alkyl darstellt,
$Z_{15}$ bei t = 1 $C_1$-$C_6$-Alkyl, Phenyl, Naphthyl oder Benzyl und bei t = 2 $C_1$-$C_6$-Alkylen, Phenylen oder Xylylen darstellt,
$Z_{16}$ unsubstituiertes oder durch Halogen, Nitro, $C_1$-$C_4$-Alkyl, $C_1$-$C_4$-Alkoxy oder $C_1$-$C_4$-Alkylthio substituiertes Phenylen oder Naphthylen oder -CH=CH- ist,
$Z_{17}$ bei t = 1 unsubstituiertes oder durch Halogen, Nitro, $C_1$-$C_4$-Alkyl oder $C_1$-$C_4$-Alkoxy substituiertes $C_1$-$C_{12}$-Alkyl oder unsubstituiertes oder durch Halogen, Nitro, $C_1$-$C_4$-Alkyl oder $C_1$-$C_4$-Alkoxy substituiertes Phenyl und bei t = 2 $C_2$-$C_8$-Alkylen oder Phenylen ist,
$Z_{18}$ unsubstituiertes oder durch Halogen, Nitro, -CN, $C_1$-$C_4$-Alkyl, Methoxy, Ethoxy, Dimethylamino oder Benzoyl substituiertes Phenyl oder Naphthyl bedeutet und die
$Z_{19}$ unabhängig voneinander $C_1$-$C_4$-Alkyl sind,
$R_{29}$ unsubstituiertes oder durch Halogen, Nitro, $C_1$-$C_4$-Alkyl oder $C_1$-$C_4$-Alkoxy substituiertes $C_1$-$C_{12}$-Alkyl oder unsubstituiertes oder durch Halogen, Nitro, $C_1$-$C_4$-Alkyl oder $C_1$-$C_4$-Alkoxy substituiertes Phenyl ist,
$R_{30}$ für $C_1$-$C_4$-Alkyl, $C_1$-$C_4$-Alkoxy oder Phenyl steht,
$R_{31}$ und
$R_{32}$ unabhängig voneinander für $C_1$-$C_4$-Alkyl, $C_1$-$C_4$-Alkoxy oder Phenyl stehen oder zusammen einen Rest der Formeln (XVII), (XVIII) oder (XIX) bedeuten

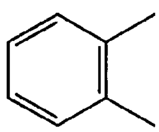 (XVII), 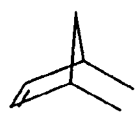 (XVIII), 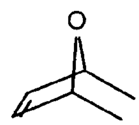 (XIX),

und
$R_{33}$ $C_1$-$C_4$-Alkyl, $C_1$-$C_4$-Alkoxy, Phenyl oder Benzoyl darstellt.

Definitionsgemässe Alkyl-, Alkoxy-, Alkylthio-, Alkylamino-, Dialkylamino-, Alkylcarbamoyl- und Alkylengruppen können hierbei geradkettig oder verzweigt sein, sind aber bevorzugt geradkettig. Halogen bedeutet insbesondere -Cl oder -Br.

Verbindungen der Formeln (VII) bis (XVI) sind z.B. in den EP-A 0 166 682 und 0 085 024 sowie der darin zitierten Literatur beschrieben. Besonders bevorzugte Verbindungen der Formeln (VII) bis (XVI) sind Phenacylp-methylbenzolsulfonat, Benzoin-p-toluolsulfonat, α-(p-Toluolsulfonyloxy)methylbenzoin-3-(p-Toluolsulfonyloxy)-2-hydroxy-2-phenyl-1-phenylpropylether, N-(p-Dodecylbenzolsulfonyloxy)-1,8-naphthalimid und N-(Phenylsulfonyloxy)-1,8-naphthalimid.

Weitere geeignete Verbindungen b) sind o-Nitrobenzaldehyde, die sich unter aktinischer Bestrahlung in o-Nitrosobenzoesäuren umlagern, wie 1-Nitrobenzaldehyd und 2,6-Dinitrobenzaldehyd; α-Halogenacylphenone, wie α,α,α-Trichloracetophenon und p-tert.Butyl-α,α,α-trichloracetophenon, sowie Sulfonsäureester von o-Hydroxyacylphenonen, wie 2-Hydroxybenzophenonmethansulfonat und 2,4-Hydroxybenzophenon-bis-(methansulfonat).

Schliesslich eignen sich als Verbindungen b) auch solche, die aromatisch gebundenes Chlor oder Brom enthalten, wie sie beispielsweise in der EP-A 0 318 649 beschrieben sind, z.B. Verbindungen der Formel (XX)

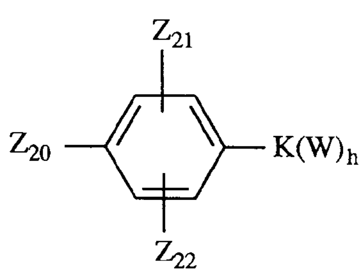 (XX)

mit mindestens einem aromatisch gebundenen Chlor- oder Bromatom, worin z.B.
p 0 oder 1 bedeutet,

$Z_{20}$ -COOH, $-OZ_{23}$ oder $-SZ_{23}$ ist,
$Z_{21}$ und
$Z_{22}$ unabhängig voneinander Wasserstoff, -Cl, -Br, gegebenenfalls durch Aryl, Alkoxy, Aryloxy, -OH oder -F substituiertes Alkyl oder gegebenenfalls durch Alkoxy, Aryloxy, -OH oder Halogen substituiertes Aryl sind,
$Z_{23}$ Wasserstoff, gegebenenfalls analog $Z_{21}$ substituiertes Alkyl oder Aryl oder Acyl ist,
K bei p =0, Wasserstoff, -Cl, -Br, gegebenenfalls analog zu $Z_{21}$ substituiertes Alkyl, bei p = 1 $-SO_2-$, Propylen oder Perfluoralkylen ist und
W eine Gruppe

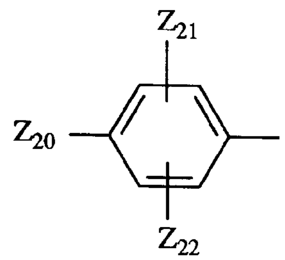

oder

Alkylcarbonyl, Alkoxycarbonyl sowie substituiertes Sulfonylimidocarbonyl bedeutet.

Beispiele derartiger Verbindungen sind Hexafluortetrabrom-Bisphenol A, 1,1,1-Tris(3,5-dibrom-4-hydroxyphenyl)ethan und N-(2,4,6-Tribromphenyl)-N'-(p-toluolsulfonyl)harnstoff.

Besonders bevorzugt verwendet man als Verbindungen b) solche der Formel (IV), worin
$Ar_1$ Phenyl bedeutet,
q die Zahl 3 ist,
r und
s Null sind, und
$X_1^{\ominus}$ $SbF_6^{\ominus}$, $AsF_6^{\ominus}$, $PF_6^{\ominus}$, $CF_3SO_3^{\ominus}$, $C_2F_5SO_3^{\ominus}$, $n\text{-}C_3F_7SO_3^{\ominus}$, $n\text{-}C_4F_9SO_3^{\ominus}$, $n\text{-}C_6F_{13}SO_3^{\ominus}$, $n\text{-}C_8F_{17}SO_3^{\ominus}$ oder $C_6F_5SO_3^{\ominus}$ darstellt.

Ganz besonders bevorzugt verwendet man als Komponente b) Triphenylsulfoniumtrifluormethansulfonat.

Die Verbindungen b) werden zweckmässig in einer Menge von 0,1-20 Gew.-%, vorzugsweise 1-10 Gew.-% und insbesondere 1-6 Gew.-%, bezogen auf das Gewicht der Komponente a), eingesetzt

Die erfindungsgemässen Zusammensetzungen können weitere übliche Zusatzstoffe enthalten, wie z.B. Stabilisatoren, Pigmente, Farbstoffe, Füllstoffe, Haftvermittler, Verlaufmittel, Netzmittel und Weichmacher. Bevorzugt sind die Zusammensetzungen zur Applikation in geeigneten Lösungsmitteln [Komponente c)] gelöst.

Obwohl nicht erforderlich, können in den erfindungsgemässen strahlenempfindlichen Zusammensetzungen auch noch weitere Polymere z. B. als Bindemittel vorhanden sein. Die Wahl dieser Bindemittel kann je nach dem Anwendungsgebiet und den hierfür geforderten Eigenschaften erfolgen. Geeignete Bindemittel sind beispielsweise Novolake, die sich von einem Aldehyd, vorzugsweise Formaldehyd, Acetaldehyd oder Furfuraldehyd, besonders jedoch von Formaldehyd, und einem Phenol ableiten. Die phenolische Komponente dieser Bindemittel ist vorzugsweise Phenol selbst, oder auch halogeniertes Phenol, beispielsweise substituiert mit ein bis zwei Chloratomen, vorzugsweise p-Chlorphenol, oder sie ist ein durch ein bis zwei $C_1$-$C_9$-Alkylgruppen substituiertes Phenol, beispielsweise o-, m- oder p-Kresol, ein Xylenol, p-tert.Butylphenol oder p-Nonylphenol. Es kann sich bei der Phenolkomponente der bevorzugten Novolake aber auch um p-Phenylphenol, Resorcin, Bis-(4-hydroxyphenyl)-methan oder 2,2-Bis(4-hydroxyphenyl)-propan handeln.

Weitere geeignete Bindemittel sind beispielsweise Copolymere von Maleinsäureanhydrid mit Styrol, Vinylethern oder 1-Alkenen. Homo- oder copolymere Acrylate und Methacrylate, z.B. Copolymere aus Methylmethacrylat/Ethylacrylat/Methacrylsäure, Poly(methacrylsäurealkylester) oder Poly(acrylsäurealkylester) mit z.B. 1-20 C-Atomen im Alkylrest lassen sich ebenfalls als Bindemittel einsetzen.

Vorzugsweise verwendet man als ein Bindemittel eine alkalilösliche Substanz, beispielsweise einen Novolak (gegebenenfalls modifiziert wie oben beschrieben), Poly(4-hydroxystyrol) oder Poly(4-hydroxy-3,5-dimethylstyrol), Copolymere von Maleinsäureanhydrid mit Styrol, Vinylethern oder 1-Alkenen, sowie Copolymere von Acrylsäure- oder Methacrylsäureestern mit ethylenisch ungesättigten Säuren, beispielsweise Methacrylsäure oder Acrylsäure.

Die in einem Lösungsmittel oder Lösungsmittelgemisch gelösten erfindungsgemässen strahlungsempfindlichen Zusammensetzungen eignen sich hervorragend als Beschichtungsmittel für Substrate aller Art, z.B. Holz, Textilien, Papier, Keramik, Glas, Kunststoffe, wie Polyester, Polyethylenterephthalat, Polyolefine oder Celluloseacetat, insbesondere in Form von Filmen, sowie Metalle, wie Al, Cu, Ni, Fe, Zn, Mg oder Co, und GaAs, Si oder $SiO_2$, auf denen durch bildmässiges Belichten eine Abbildung aufgebracht werden soll.

Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder enfernt werden können. Geeignete Lösungsmittel sind z.B. Ketone, Ether und Ester, wie Methylethylketon, 2-Heptanon, Cyclopentanon, Cyclohexanon, γ-Butyrolacton, Ethylpyruvat, Diethylenglykoldimethylether, 2-Methoxyethanol, 2-Ethoxyethanol, 2-Ethoxyethylacetat, 1-Methoxy-2-propylacetat, 1,2-Dimethoxyethan, Essigsäureethylester und 3-Methoxymethylpropionat.

Die erfindungsgemässen Zusammensetzungen werden bevorzugt als Positivphotoresist verwendet. Daher bildet ein Verfahren zur Behandlung eines Substrats, das die folgenden Verfahrensmassnahmen in der angegebenen Reihenfolge umfasst einen weiteren Gegenstand der Erfindung:

1. Aufbringen einer Beschichtung bestehend aus einer der oben beschriebenen Zusammensetzungen auf dem Substrat;
2. bildmässige Belichtung der Beschichtung mit Hilfe von aktinischer Strahlung;
3. Behandlung der Beschichtung mit einem Entwickler auf Basis einer wässerigalkalischen Lösung, bis sich der Strahlung ausgesetzte Partien der Beschichtung vom Substrat lösen und eine bildmässig strukturierte Beschichtung auf dem Substrat verbleibt.

Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Rollbeschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und die Art des Substrats (Schichtträger) sind vom gewünschten Applikationsgebiet abhängig. Der Schichtdickenbereich umfasst im allgemeinen Werte von ca. 0,1 μm bis mehr als 10 μm.

Nach dem Beschichten wird das Lösungsmittel in der Regel durch Trocknen entfernt, und es resultiert eine Schicht der erfindungsgemässen Zusammensetzung auf dem Träger.

Die erfindungsgemässen strahlungsempfindlichen Zusammensetzungen eignen sich als Photoresists für die Elektronik (Galvanoresist, Aetzresist, Lötstoppresist), für die Herstellung von Druckplatten, wie Offsetdruckplatten oder Siebdruckformen, für den Einsatz beim Formteilätzen oder den Einsatz als Mikroresist bei der Herstellung integrierter Schaltkreise. Dementsprechend unterschiedlich sind die möglichen Schichtträger und die Verarbeitungsbedingungen der beschichteten Substrate.

Als Substrat für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 μm bis 10 μm, für gedruckte Schaltungen 0,4 bis ca. 2 μm.

Zur Herstellung von Reliefstrukturen wird das mit der erfindungsgemässen Zusammensetzung beschichtete Substrat bildmässig belichtet. Der Begriff 'bildmässige' Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteten Substrates bewegt wird, und auf diese Weise ein Bild erzeugt, die Bestrahlung mit computergesteuerten Elektronenstrahlen, sowie die Bestrahlung mit Röntgen- oder UV-Strahlen durch eine entsprechende Maske.

Als Strahlungsquellen können im Prinzip sämtliche Lampen verwendet werden, die Strahlung im UV-Bereich emittieren. Es sind sowohl Punktlichtquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen, photographische Flutlichtlampen, Elektronenstrahlen und Röntgenstrahlen. Der Abstand zwischen Lampe und erfindungsgemässem Bildmaterial kann je nach Anwendungszweck und Lampentyp bzw. -stärke variieren, z.B. zwischen 2 cm bis 150 cm. Speziell geeignet sind Laserlichtquellen, z.B. Argonionenlaser oder Kryptonionenlaser. Mit Laserlicht kann der Resist auch ohne Maske belichtet werden, indem der gesteuerte Laser-Strahl direkt auf der Resist-Schicht schreibt. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elektronikindustrie, lithographische Offsetdruckplatten oder Reliefdruckplatten sowie photographische Bildaufzeichnungsmaterialien hergestellt werden. Die hohe Empfindlichkeit der Resists ist auch für die Belichtung mittels DUV-Stepper von Vorteil, da sehr kurze Belichtungszeiten erwünscht sind.

Bevorzugt umfasst das zuvor beschriebene Verfahren zur Herstellung von Reliefstrukturen zwischen Belichtung und Behandlung mit dem Entwickler die Erwärmung der Beschichtung als eine weitere Verfahrensmassnahme. Mit Hilfe dieser Wärmebehandlung, dem sogenannten "post exposure bake", erreicht man eine praktisch vollständige Reaktion der säureempfindlichen Gruppen im Polymergerüst mit der durch die Belichtung erzeugten Säure. Die Dauer und die Temperatur dieses post exposure bake können in weiten Bereichen variieren und hängen im wesentlichen von der Zusammensetzung des säureempfindlichen Polymeren und von der Art des verwendeten Säuregenerators sowie von den Konzentrationen dieser beiden Komponenten ab. Üblicherweise wird der belichtete Resist wenige Sekunden bis einige Minuten Temperaturen von etwa 50-150 °C ausgesetzt. Überraschenderweise ist bei den erfindungsgemässen Resists die delay time, bei der noch keine T-tops auftreten, im Vergleich zu den bisher bekannten Positiv-Photoresist-Systemen, z.B. den in der EP-A 366 590 oder der EP-A 342 498 beschriebenen Positiv-Resists, wesentlich verlängert.

Nach der in üblicher Weise erfolgten bildmässigen Belichtung und gegebenenfalls durchgeführten Wärmebehandlung des Materials werden die belichteten Stellen des Photolackes durch Herauslösen in einem Entwickler entfernt.

Die Wahl des jeweiligen Entwicklers richtet sich nach der Art des Photolackes, insbesondere nach der Natur des verwendeten Bindemittels oder der entstehenden Photolyseprodukte. Der Entwickler kann wässrige Lösungen von Basen umfassen, denen gegebenenfalls organische Lösungsmittel oder deren Mischungen zugesetzt wurden.

Besonders bevorzugt als Entwickler werden wässrig alkalische Lösungen, wie sie auch für die Entwicklung von Novolak-Naphthochinondiazid-Resistbeschichtungen eingesetzt werden. Dazu zählen z. B. wässrige Lösungen von Alkalimetallsilikaten, -phosphaten, -hydroxiden und -carbonaten, insbesondere aber von Tetraalkylammoniumhydroxidlösungen, wie z. B. von Tetramethylammoniumhydroxidlösung. Diesen Lösungen können gegebenenfalls noch kleinere Mengen an Netzmitteln und/oder organischen Lösungsmitteln zugesetzt sein.

Typische organische Lösungsmittel, die den Entwicklerflüssigkeiten zugesetzt werden können, sind beispielsweise Cyclohexanon, 2-Ethoxyethanol, Toluol, Aceton, Isopropanol, Ethanol, sowie Mischungen zweier oder mehrerer dieser Lösungsmittel.

Abgesehen von den stark reduzierten delay time-Effekten und den anderen oben schon genannten Vorteilen zeichnen sich die erfindungsgemässen Resistzusammensetzungen unter anderem noch durch gute anwendungstechnische Eigenschaften sowie eine hohe optische Transparenz, hohe thermische Stabilität und ein sehr gutes Auflösungsvermögen (Submikronbereich) aus.

Im allgemeinen wird nach dem Entwicklungsschritt das die bildmässig strukturierte Beschichtung aufweisende Substrat zumindest auf der beschichteten Seite mindestens einem weiteren Behandlungsschritt unterzogen, der an den freien Stellen des Substrats zu einer Veränderung des Substrats führt. Gegebenenfalls folgt danach als eine zusätzliche Verfahrensmassnahme die Entfernung der strukturierten Resistbeschichtung von dem Substrat.

Einen weiteren Gegenstand der Erfindung stellt ein Verfahren zur Herstellung eines elektronischen Bauelementes dar, das ein Verfahren zur Behandlung eines Substrats, wie es oben beschrieben wurde, umfasst.

Auch die unter Verwendung der erfindungsgemässen Photoresistzusammensetzungen hergestellten Schutzschichten und Reliefstrukturen stellen einen Erfindungsgegenstand dar.

Beispiel 1:

Herstellung von (4-Vinylphenoxy)-essigsäure-tert.-butylester.

In einem 750 ml Sulfierkolben werden 59,3 g (430 mMol) Kaliumcarbonat, 0,64 g Kaliumjodid, 50,7g (260 mMol) Bromessigsäure-tert.-butylester und 31,2 g (260mMol) 4-Hydroxystyrol mit 145 ml Aceton versetzt. Die resultierende Suspension wird während 100 Minuten am Rückfluss gekocht, nach dem Abkühlen filtriert und eingeengt. Der erhaltene Rückstand wird in 750 ml Ether aufgenommen und zweimal mit je 100 ml 1N NaOH-Lösung, danach zweimal mit je 200 ml Wasser gewaschen. Die organische Phase wird abgetrennt, über Magnesiumsulfat getrocknet und eingeengt, wobei 60,02 g (256 mMol) des gewünschten Produkts als klares Öl zurückbleiben, was einer Ausbeute von 98,5 % der Theorie entspricht.

| | |
|---|---|
| $^1$H-NMR ($CDCl_3$, 300MHz): δ[ppm] des erhaltenen Produkts | 7,33/d/2H<br>6,84/d/2H<br>6,64/dd/1H<br>5,60/d/1H<br>5,12/d/1H<br>4,49/s/2H<br>1,47/s/9H |

Beispiel 2:

Herstellung eines Copolymers aus (4-Vinylphenoxy)-essigsäure-tert.-butylester und N-Hydroxymethylmaleinimid.

In einem ausgeflammten 150 ml Sulfierkolben werden 8,0 g (34,1 mMol) (4-Vinylphenoxy)-essigsäure-tert.-butylester, 4,3 g (34,1 mMol) N-Hydroxymethylmaleinimid, 0,25 g Azobisisobutyronitril und 0,43 g 1-Dodekylthiol in 86 ml Diglyme gelöst. Nach dreimaligem Spülen mit Stickstoff lässt man während 2 Stunden bei 75 °C reagieren und fällt danach in 1 Liter n-Hexan. Der resultierende weisse Niederschlag wird getrocknet, danach in 40 ml Tetrahydrofuran gelöst und aus 500 ml Isopropanol ausgefällt. Nach dem Trocknen resultieren 7,6 g eines weissen Pulvers (62 % der Theorie).

| | | |
|---|---|---|
| $^1$H-NMR (Aceton-d6, 300MHz): δ[ppm] des erhaltenen Produkts | 6,8<br>5,2<br>4,8<br>4,6<br>4,0 - 1,7<br>1,5 | |
| GPC (Polystyroleichung): | $M_w$ | 19100 |
| | $M_n$ | 8650 |
| | PD | 2,2 |
| TGA (10°C/min): | 24,5% Gewichtsverlust<br><br>zwischen 160 und 220 °C. | |

Beispiel 3:

Herstellung eines Terpolymers aus (4-Vinylphenoxy)-essigsäure-tert.-butylester, N-Hydroxymethylmaleinimid und N-(Acetoxymethyl)maleinimid.

Analog zu Beispiel 2 werden aus 35,15 g (150 mMol) (4-Vinylphenoxy)-essigsäure-tert.-butylester, 4,19 g (33 mMol) N-Hydroxymethylmaleinimid, 19, 77 g (117 mMol) N-(Acetoxymethyl)maleinimid, 0,6 g Azobisisobutyronitril und 2,1 g 1-Dodekylthiol, gelöst in 400 ml Diglyme, 49,44 g eines weissen Pulvers erhalten (83 % der Theorie).

| | | |
|---|---|---|
| $^1$H-NMR (Aceton-d6, 300MHz): δ[ppm] des erhaltenen Produkts | 7,0 - 6,5/m<br>5,5 - 5,1/m<br>4,9 - 4,4/m<br>2,8/s<br>2,0/bs<br>1,5/m | |
| GPC (Polystyroleichung): | $M_w$<br>$M_n$<br>PD | 19150<br>9070<br>2,1 |
| TGA (10°C/min): | 14% Gewichtsverlust zwischen 164 und 201 °C. | |

Beispiel 4:

Herstellung eines Copolymers aus (4-Vinylphenoxy)-essigsäure-tert.-butylester und N-(Acetoxymethyl)maleinimid.

Analog zu Beispiel 2 werden aus 8,0 g (34,1 mMol) (4-Vinylphenoxy)-essigsäure-tert.-butylester, 6,2 g (34,1 mMol) N-(Acetoxymethyl)maleinimid, 0,25 g Azobisisobutyronitril und 0,43 g 1-Dodekylthiol, gelöst in 86 ml Diglyme, 8,9 g eines weissen Pulvers erhalten (63 % der Theorie).

| | | |
|---|---|---|
| $^1$H-NMR ($CDCl_3$, 300MHz): δ[ppm] des erhaltenen Produkts | 6,8<br>5,1<br>4,8<br>4,6<br>4,0 - 1,7<br>2,1<br>1,5 | |
| GPC (Polystyroleichung): | $M_w$<br>$M_n$<br>PD | 19700<br>8650<br>2,3 |
| TGA (10°C/min): | 20% Gewichtsverlust zwischen 170 und 220 °C. | |

Beispiel 5:

Herstellung eines Copolymers aus 4-Ethenylbenzolessigsäuretetrahydro-2H-pyran-2-ylester und N-Hydroxymethylmaleinimid.

a) In einem 250 ml Dreihalsrundkolben werden unter Stickstoff-Inertatmosphäre 5.3 g (220 mMol) Magnesiumspäne mit 150 ml Diethylether versetzt. Danach wird mit 30,5 g (200 mMol) Vinylbenzylchlorid versetzt und für 1 Stunde unter Rückfluss erhitzt. Zur auf 5 °C abgekühlten Suspension wird danach solange $CO_2$ eingeleitet, bis mit Hilfe eines Thermometers keine Exothermie mehr erkennbar ist (ca. 9 g ). Danach wird auf 400 ml 1N Salzsäure gegossen. Man extrahiert zweimal mit Ether. Die vereinigten Etherphasen werden dann mit 500 ml Wasser gewaschen, über Magnesiumsulfat getrocknet und eingeengt. Das resultierende Öl wird aus einer Mischung aus 50 ml Toluol und 150 ml n-Hexan umkristallisiert, wobei 7,1 g (22 % d. Th.) (4-Vinylphenyl)essigsäure als weisses Pulver vom Schmelzpunkt 94 °C anfallen.

| | |
|---|---|
| $^1H$-NMR ($CDCl_3$, 300 MHz): $\delta$[ppm] | 11,5 - 11,0/s/1H |
| | 7,4 - 7,1/m/4H |
| | 6,67/dd/1H |
| | 5,72/dd/1H |
| | 5,23/dd/1H |
| | 3,59/s/2H |

b) In einem 50 ml Dreihalsrundkolben mit Magnetrührer und Stickstoffüberleitung wird ein Gemisch aus 7 g (43 mMol) der (4-Vinylphenyl)essigsäure, 12,0 g (142 mMol) 3,4-Dihydro-2H-pyran und 2 Tropfen 32%-ige Salzsäure während 90 Minuten auf 45 °C erwärmt. Danach wird mit 100 ml Ether versetzt. Die organische Phase wird anschliessend zweimal mit je 50 ml 1N Natriumhydroxidlösung und zweimal mit je 50 ml Wasser gewaschen, über Magnesiumsulfat getrocknet und eingeengt. Dabei resultiert ein farbloses Öl, welches aus der dreifachen Menge n-Hexan umkristallisiert wird. Man erhält 7,5 g (70 % d. Th.) (4-Vinylphenyl)essigsäuretetrahydro-2H-pyran-2-ylester mit einem Schmelzpunkt von 34 °C.

| | |
|---|---|
| $^1H$-NMR ($CDCl_3$, 300 MHz): $\delta$[ppm] | 7,4 - 7,1/m/4H |
| | 6,68/dd/1H |
| | 5,98/dd/1H |
| | 5,73/dd/1H |
| | 5,22/dd/1H |
| | 4,0 - 3,7/m/2H |
| | 3,64/s/2H |
| | 1,9 - 1,5/m/6H |

c) in einem 100 ml Rundkolben werden 4,9 g (20 mMol) (4-Vinylphenyl)essigsäuretetrahydro-2H-pyran-2-ylester, 2,5 g (20 mMol) N-Hydroxymethylmaleinimid, 0,15 g Azobisisobutyronitril und 0,26 g 1-Dodekanthiol mit 52 g Diglyme versetzt. Man erhitzt während 2 Stunden auf 75 °C und fällt anschliessend aus 600 ml Isopropanol. Der weisse Niederschlag wird abfiltriert, in 50 ml THF gelöst und nochmals aus 600 ml Isopropanol gefällt. Nach dem Trocknen des Niederschlags erhält man 3,4 g (46 % d. Th.) des gewünschten Copolymers.

| | | |
|---|---|---|
| $^1$H-NMR ($CDCl_3$, 300 MHz): δ[ppm] | 7,5 - 6,8<br>6,0 - 5,6<br>5,2 - 4,4<br>3,9 - 1,5 | |
| GPC (Polystyroleichung): | $M_w$<br>$M_n$ | 18500<br>9300 |
| TGA (10 °C/min): | 31% Gewichtsverlust zwischen 100 und 200 °C. | |

Beispiel 6:

Applikation des Terpolymers aus Beispiel 3.

3,84 g des Terpolymers aus Beispiel 3 werden zusammen mit 0,16 g Triphenylsulfoniumtrifluoromethylsulfonat (hergestellt nach der Vorschrift von J. L. Dektar und N. P. Hacker, JACS 112 (1990), S. 6004) in 16 g 1-Methoxy-2-propylacetat gelöst. Die resultierende Lösung wird nach Feinstfiltration (0,2 μm) derart auf einen 100 mm Siliziumwafer aufgeschleudert, dass nach einer 60 Sekunden währenden Trocknung bei 120 °C auf der Wärmeplatte ein Resistfilm mit einer Dicke von 850 nm auf dem Wafer zurückbleibt. Die sich anschliessende Belichtung erfolgt mit einem 5:1 Projektionsbelichter (Canon FPA 4500, N. A. 0,37) mit einer Strahlung von 248 nm Wellenlänge bei Steigerung der Belichtungsdosis in Schritten von 0,5 mJ/cm². Danach wird die Probe 60 Sekunden auf einer Wärmeplatte auf 100 °C erhitzt und schliesslich wird 60 Sekunden in wässeriger 0,262 N Tetramethylammoniumhydroxidlösung (TMAH) entwickelt. Bei einer Belichtungsdosis von 6 mJ/cm² können positive Abbilder von Teststrukturen erhalten werden, wobei eine Auflösung von 0,35 μm (lines and spaces) erreicht wird.

Beispiel 7:

Applikation des Copolymers aus Beispiel 2.

3,84 g des Copolymers aus Beispiel 2 werden zusammen mit 0,16 g Triphenylsulfoniumtrifluoromethylsulfonat wie in Beispiel 6 in 1-Methoxy-2-propylacetat gelöst und auf einem 100 mm Siliziumwafer aufgebracht. Die Resistfilmdicke beträgt 859 nm. Nach einer gemäss Beispiel 6 durchgeführten Belichtung, Erhitzen der Probe auf 90 °C während 60 Sekunden und einer 60-sekündigen Entwicklung in wässeriger 0,0262 N Tetramethylammoniumhydroxidlösung (TMAH) zeigt sich, dass bei Belichtung mit einer Strahlungsdosis von 13 mJ/cm² abbildungstreue positive Resiststrukturen mit einer Auflösung von 0,30 μm erhalten werden können.

Beispiel 8:

Applikation des Copolymers aus Beispiel 4.

3,84 g des Copolymers aus Beispiel 2 werden zusammen mit 0,16 g Triphenylsulfoniumtrifluoromethylsulfonat wie in Beispiel 6 in 16 g 1-Methoxy-2-propylacetat gelöst und auf einem 100 mm Siliziumwafer aufgebracht. Die Resistfilmdicke beträgt 850 nm. Danach wird gemäss Beispiel 6 weiterverfahren. Es zeigt sich, dass bei Belichtung mit einer Strahlungsdosis von 42 mJ/cm² abbildungstreue positive Submikrometerstrukturen abgebildet werden können.

Beispiel 9:

Herstellung eines Copolymers aus 2-Methyl-2-(4-Vinylphenoxy)-propionsäure-tert.-butylester und N-Hydroxymethylmaleinimid.

Analog zu Beispiel 2 werden aus 9,0 g (34 mMol) 2-Methyl-2-(4-Vinylphenoxy)-propionsäure-tert.-butylester, 4,8 g (38 mMol) N-Hydroxymethylmaleinimid, 0,3 g Azobisisobutyronitril und 0,52 g 1-Dodekylthiol, gelöst in 100 ml Diglyme, 11,6 g eines weissen Pulvers erhalten (80 % der Theorie).

| | | |
|---|---|---|
| $^1$H-NMR ($CDCl_3$, 300MHz): δ[ppm] des erhaltenen Produkts | 6,7<br>4,8<br>3,8 - 1,1 | |
| GPC (Polystyroleichung): | $M_w$<br>$M_n$<br>PD | 14030<br>6750<br>2,0 |
| TGA (10°C/min): | 22% Gewichtsverlust zwischen 160 und 220 °C | |
| DSC (10°C/min): | Tg = 127°C. | |

Beispiel 10:

Herstellung eines Terpolymers aus 2-Methyl-2-(4-Vinylphenoxy)-propionsäure-tert.-butylester, N-Hydroxymethylmaleinimid und N-(Acetoxymethyl)maleinimid.

Analog zu Beispiel 2 werden aus 35 g (133 mMol) 2-Methyl-2-(4-Vinylphenoxy)-propionsäure-tert.-butylester, 8,45 g (66 mMol) N-Hydroxymethylmaleinimid, 11,25 g (67 mMol) N-(Acetoxymethyl)maleinimid, 1,1 g Azobisisobutyronitril und 1,9 g 1-Dodekylthiol, gelöst in 380 ml Diglyme, 47,3 g eines weissen Pulvers erhalten (86 % der Theorie).

| | | |
|---|---|---|
| $^1$H-NMR ($CDCl_3$, 300MHz): δ[ppm] des erhaltenen Produkts | 6,7<br>5,25<br>4,8<br>3,8 - 1,1 | |
| GPC (Polystyroleichung): | $M_w$<br>$M_n$<br>PD | 15220<br>5800<br>2,6 |
| TGA (10°C/min): | 13% Gewichtsverlust zwischen 180 und 220 °C. | |

Beispiel 11:

Herstellung eines Terpolymers aus (4-Vinylphenoxy)essigsäure-tert.-butylester, Maleinimid und N-(Acetoxymethyl)maleinimid.

Analog zu Beispiel 2 werden aus 15,05 g (64 mMol) (4-Vinylphenoxy)essigsäure-tert.-butylester, 3,12 g (32 mMol) Maleinimid, 5,43 g (32 mMol) N-(Acetoxymethyl)maleinimid, 0,47 g Azobisisobutyronitril und 0,83

g 1-Dodekylthiol, gelöst in 165 ml Diglyme, 11,7 g eines weissen Pulvers erhalten (49 % der Theorie).

| | | |
|---|---|---|
| $^1$H-NMR ($CDCl_3$, 300 MHz): δ[ppm] des erhaltenen Produkts | 6,7 | |
| | 5,3 | |
| | 4,5 | |
| | 3,5 - 1,2 | |
| GPC (Polystyroleichung): | $M_w$ | 16220 |
| | $M_n$ | 9900 |
| | PD | 1,64 |
| TGA (10°C/min): | 15% Gewichtsverlust zwischen 170 und 220 °C. | |

Beispiel 12:

Herstellung eines Terpolymers aus (4-Vinylbenzol)essigsäure-tert.-butylester, N-Hydroxymethylmaleinimid und N-(Acetoxymethyl)maleinimid.

Analog zu Beispiel 2 werden aus 9,0 g (41 mMol) (4-Vinylbenzol)essigsäure-tert.-butylester, 2,62 g (20 mMol) N-Hydroxymethylmaleinimid, 3,49 g (21 mMol) N-(Acetoxymethyl)maleinimid, 0,30 g Azobisisobutyronitril und 0,53 g 1-Dodekylthiol, gelöst in 106 ml Diglyme, 14,4 g eines weissen Pulvers erhalten (95 % der Theorie).

| | | |
|---|---|---|
| $^1$H-NMR ($CDCl_3$, 300MHz): δ[ppm] des erhaltenen Produkts | 7,1 | |
| | 5,3 | |
| | 4,8 | |
| | 3,7 - 1,2 | |
| GPC (Polystyroleichung): | $M_w$ | 12540 |
| | $M_n$ | 5240 |
| | PD | 2,39 |
| TGA (10°C/min): | 18% Gewichtsverlust zwischen 170 und 230 °C. | |

Beispiel 13:

Herstellung eines Copolymers aus (4-Vinylbenzol)essigsäure-tert.-butylester und N-Hydroxymethylmaleinimid.

Analog zu Beispiel 2 werden aus 1,5 g (6,9 mMol) (4-Vinylbenzol)essigsäure-tert.-butylester, 0,87 g (6,9 mMol) N-Hydroxymethylmaleinimid, 0,05 g Azobisisobutyronitril und 0,08 g 1-Dodekylthiol, gelöst in 16 ml Diglyme, 2,25 g eines weissen Pulvers erhalten (94 % der Theorie).

| | |
|---|---|
| $^1$H-NMR ($CDCl_3$, 300MHz): δ[ppm] des erhaltenen Produkts | 7,0<br>4,8<br>3,4<br>3,3 - 1,1 |

| | | |
|---|---|---|
| GPC (Polystyroleichung): | $M_w$ | 11670 |
| | $M_n$ | 4685 |
| | PD | 2,5 |
| TGA (10°C/min): | 25% Gewichtsverlust zwischen 150 und 230 °C | |
| DSC (10°C/min): | Tg = 115°C. | |

Beispiel 14:

Applikation des Terpolymers aus Beispiel 3.

Es wird eine Lösung enthaltend 3,84 g der Terpolymers aus Beispiel 3 und 0,16 g Triphenylsulfoniumtrifluoromethansulfonat, gelöst in 16 g 1-Methoxy-2-propylacetat, hergestellt und auf einen Siliziumwafer aufgeschleudert, analog zu Beispiel 6. Nach der Trocknung bei 100 °C während 60 Sekunden wird der Resistfilm mit Hilfe eines GCA XLS Projektionsbelichters (N. A. 0.53) mit 60 Dosiseinheiten bei einer Wellenlänge von 248 nm bildmässig belichtet. Anschliessend wird der Siliziumwafer während 60 Sekunden auf 90 °C erhitzt und schliesslich während 2 Minuten in einer wässerigen 0,131N Tetramethylammoniumhydroxidlösung entwickelt. Dabei werden positive Strukturen bis runter auf 0,25 Mikrometer (lines/spaces) massgetreu und rückstandsfrei abgebildet.

Beispiel 15:

Herstellung von 2-(4-Vinylphenoxy)-2-methoxypropan.

In einem 1500 ml Sulfierkolben werden unter Stickstoffatmosphäre 72,1 g (600 mMol) 4-Hydroxystyrol in einem Gemisch aus 300 ml Diethylether und 150 ml Dioxan gelöst. Man fügt 216,3 g (3000 mMol) 2-Methoxypropen hinzu und kühlt auf 10 °C. Dann werden tropfenweise während 20 Minuten 1,48 g (7,8mMol) p-Toluolsulfonsäure in 28,5 g (360 mMol) Pyridin zugegeben und es wird 20 Stunden bei Raumtemperatur gerührt. Das Reaktionsgemisch wird dreimal mit 300 ml 0,2 N NaOH und dreimal mit 300 ml deionisiertem Wasser gewaschen. Die organische Phase wird mit Magnesiumsulfat getrocknet, über 1cm Amberlyst A27 filtriert und im Rotationsverdampfer eingedampft. Weiteres Trocknen des hierbei erhaltenen Rückstandes unter Hochvakuum ergibt 99,2 g (82 % der Theorie) des gewünschten Produkts in Form eines gelben Öls.

| | |
|---|---|
| $^1$H-NMR ($CDCl_3$, 300MHz): δ[ppm] des erhaltenen Produkts | 7,30/d/ 2H<br>7,05/d/ 2H<br>6,67/dd/ 1H<br>5,63/d/ 1H<br>5,14/d/ 1H<br>3,41/s/ 3H<br>1,47/s/ 6H. |

Beispiel 16:

Herstellung eines Terpolymers aus 2-(4-Vinylphenoxy)-2-methoxypropan, N-Hydroxymethylmaleinimid und N-(Acetoxymethyl)maleinimid.

Unter Gelblicht werden in einen ausgeflammten 1000 ml Sulfierkolben 50 g (260 mMol) 2-(4-Vinylphenoxy)-2-methoxypropan, 17 g (130 mMol) N-Hydroxymethylmaleinimid, 22 g (130 mMol) N-(Acetoxymethyl)maleinimid, 3,1 g 1-Dodekylthiol, 1,8 g (4-Morpholino-benzoyl)-1-benzyl-1-dimethylamino-propan (Irgacure®369) und 600 g Tetrahydrofuran gegeben. Die erhaltene Lösung wird dreimal mit Hilfe von Argon entgast und dann 1 Stunde mit einer UV-Lampe (500 Watt Oriel-Ushio Mercury Lamp) belichtet. Nach der Belichtung wird die Reaktionsmischung 1 Stunde bei Raumtemperatur gerührt und das Produkt in 800 ml Methanol gefällt. Nach dem Trocknen bei 40 °C unter Vakuum resultieren 54,5 g eines weissen Pulvers (61 % der Theorie).

| | | |
|---|---|---|
| $^1$H-NMR (Aceton-d6, 300MHz): δ[ppm] des erhaltenen Produkts | 6,7<br>5,25<br>4,8<br>3,8 - 2<br>1,4 | |
| GPC (Polystyroleichung): | $M_w$<br>$M_n$<br>PD | 31600<br>15100<br>2,1 |
| TGA (10°C/min): | 25,1% Gewichtsverlust zwischen 130 und 220 °C. | |

Beispiel 17:

Herstellung von 1-(4-Vinylphenoxy)-1-tert.-butoxyethan.

In einen 250 ml Dreihalskolben werden unter Stickstoffatmosphäre 12,02g (100 mMol) 4-Hydroxystyrol, 0,09g p-Toluolsufonsäure und 100 ml Diethylether gegeben. Man kühlt auf 0 bis 5 °C und gibt bei dieser Temperatur während 15 Minuten tropfenweise 11,02 g (110 mMol) tert.-Butylvinylether zu. Dann wird 2 Stunden bei 10 °C gerührt. Das Reaktionsgemisch wird dreimal mit 150 ml 1 N NaOH und dreimal mit deionisiertem Wasser gewaschen. Nach Abziehen des Lösungsmittels werden 16 g (72 % der Theorie) des gewünschten Produkts in Form eines gelben Öls erhalten.

| | |
|---|---|
| $^1$H-NMR ($CDCl_3$, 300MHz): δ[ppm] des erhaltenen Produkts | 7,31/d/ 2H<br>6,90/d/ 2H<br>6,64/dd/ 1H<br>5,55/m/ 2H<br>5,12/d/ 1H<br>1,44/d/ 3H<br>1,24/s/ 9H. |

Beispiel 18:

Herstellung eines Terpolymers aus 1-(4-Vinylphenoxy)-1-tert.-butoxyethan, N-Hydroxymethylmaleinimid und N-(Acetoxymethyl)maleinimid.

In einen ausgeflammten Rundkolben werden 7,5 g (34 mMol) 1-(4-Vinylphenoxy)-1-tert.-butoxyethan, 1,3 g (10,2 mMol) N-Hydroxymethylmaleinimid, 4,0 g (23,8 mMol) N-(Acetoxymethyl)maleinimid, 0,26 g Azobisisobutyronitril, 0,45 g 1-Dodekylthiol und 90 g Diglyme gegegeben. Die erhaltene Lösung wird dreimal mit Hilfe von Stickstoff entgast und dann 2 Stunden bei einer Temperatur von 75 °C gerührt. Danach wird das Produkt in 900 ml Diethylether gefällt. Das gefällte Produkt wird abfiltriert, getrocknet, 60 ml Aceton gelöst und in 700 ml Diethylether gefällt. Nach erneuter Filtration und Trocknung unter Hochvakuum resultieren 6,76 g eines weissen Pulvers (52 % der Theorie).

| | | |
|---|---|---|
| $^1$H-NMR (Aceton-d6, 300MHz): δ[ppm] des erhaltenen Produkts | 6,8<br>5,5 - 5,0<br>2,0<br>1,6<br><br>1,25 | |
| GPC (Polystyroleichung): | $M_w$ | 44200 |
| | $M_n$ | 20600 |
| | PD | 2,1 |
| TGA (10°C/min): | 27,8% Gewichtsverlust zwischen 140 und 230 °C. | |

**Patentansprüche**

1. Polymer, das wiederkehrende Struktureinheiten, ausgewählt aus den Struktureinheiten der Formeln (Ia) und (Ib)

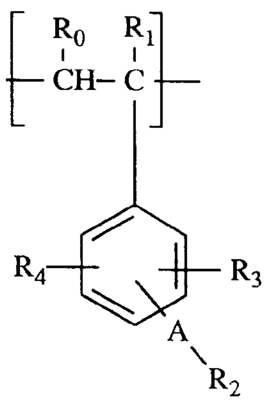

(Ia)

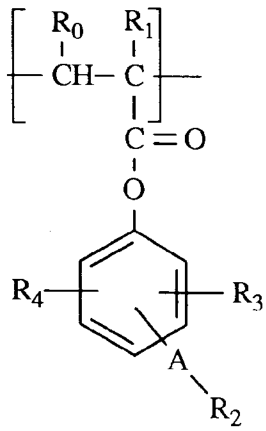

(Ib),

sowie ausser diesen Struktureinheiten wiederkehrende Struktureinheiten der Formel (II) enthält

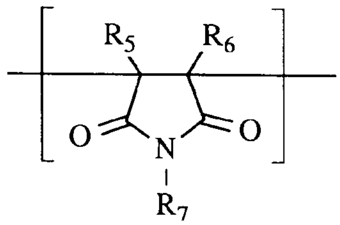

(II),

wobei

A eine direkte Einfachbindung oder eine zweiwertige Gruppe der Formel -O- bedeutet;

$R_0$ und

$R_1$ unabhängig voneinander jeweils ein Wasserstoffatom, eine $C_1$-$C_6$-Alkylgruppe oder eine Arylgruppe mit 6 bis 14 Ringkohlenstoffatomen darstellen;

$R_2$ einen Rest der Formel

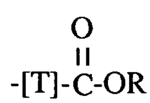

oder

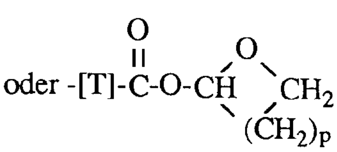

darstellt, worin

[T] für eine $C_1$-$C_6$-Alkylengruppe oder für eine Arylengruppe mit 6 bis 14 Ringkohlenstoffatomen,

R für einen tert.-Alkylrest mit 4 bis 19 Kohlenstoffatomen oder für eine Gruppe der Formel

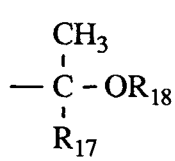

oder

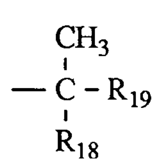

und

p für eine der Zahlen 2, 3 oder 4 stehen; oder

A zusammen mit $R_2$ eine Gruppe der Formel

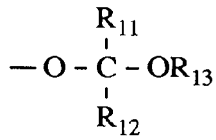

darstellt; und wobei weiterhin

$R_3$ und

$R_4$ unabhängig voneinander jeweils ein Wasserstoffatom, ein Halogenatom, eine $C_1$-$C_6$-Alkylgruppe oder eine $C_1$-$C_6$-Alkoxygruppe darstellen;

$R_5$ und

$R_6$ unabhängig voneinander jeweils ein Wasserstoffatom, eine $C_1$-$C_6$-Alkylgruppe oder eine Arylgruppe mit 6 bis 14 Ringkohlenstoffatomen darstellen und

$R_7$ ein Wasserstoffatom, eine Hydroxylgruppe, eine Trialkylsilylgruppe, eine $C_1$-$C_6$-Alkylgruppe, eine Arylgruppe mit 6 bis 14 Ringkohlenstoffatomen oder eine Gruppe der Formel -[G]-O-$R_8$ darstellt, worin

[G] für eine $C_1$-$C_6$-Alkylengruppe oder für eine Arylengruppe mit 6 bis 14 Ringkohlenstoffatomen und

$R_8$ für ein Wasserstoffatom, eine Trialkylsilylgruppe oder einen Rest der Formel

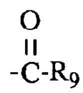

stehen, worin

$R_9$ ein Wasserstoffatom oder eine Methylgruppe bedeutet, oder $R_7$ eine Gruppe der Formel

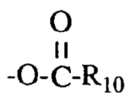

darstellt, worin

$R_{10}$ eine $C_1$-$C_6$-Alkylgruppe oder eine Arylgruppe mit 6 bis 14 Ringkohlenstoffatomen bedeutet;

$R_{11}$ sowie

$R_{12}$ unabhängig voneinander jeweils ein Wasserstoffatom, eine $C_1$-$C_6$-Alkylgruppe, eine Cycloalkylgruppe mit 3 bis 6 Ringkohlenstoffatomen oder eine Arylgruppe mit 6 bis 10 Ringkohlenstoffatomen bedeuten, wobei Arylgruppen entweder unsubstituiert sind oder einen oder mehrere Substituenten aufweisen, ausgewählt aus Halogenidatomen, $C_1$-$C_4$-Alkyl- und $C_1$-$C_4$-Alkoxygruppen sowie -CN und -$NO_2$;

$R_{13}$ eine $C_1$-$C_6$-Alkylgruppe, eine Cycloalkylgruppe mit 3 bis 6 Ringkohlenstoffatomen oder eine Arylgruppe mit 6 bis 10 Ringkohlenstoffatomen bedeutet, wobei Arylgruppen entweder unsubstituiert sind oder einen oder mehrere Substituenten aufweisen, ausgewählt aus Halogenidatomen, $C_1$-$C_4$-Alkyl- und $C_1$-$C_4$-Alkoxygruppen sowie -CN und -$NO_2$; und

$R_{17}$ ein Wasserstoffatom oder eine $C_1$-$C_4$-Alkylgruppe;

$R_{18}$ eine $C_1$-$C_6$-Alkylgruppe oder eine $C_3$-$C_6$-Cycloalkylgruppe sowie

$R_{19}$ eine Arylgruppe mit 6 bis 14 Ringkohlenstoffatomen bedeuten.

**2.** Polymer nach Anspruch 1 mit einem Molekulargewicht (Gewichtsmittel) $M_w$ von 1000 bis 1000000, gemessen mittels Gelpermeationschromatographie.

**3.** Polymer nach Anspruch 1 oder 2, das nur wiederkehrende Strukturelemente der Formeln (Ia), (Ib) und (II) aufweist.

**4.** Polymer nach Anspruch 3 bestehend aus wiederkehrenden Strukturelementen der Formel (Ia) sowie der Formel (II), wobei

A die Gruppe -O- bedeutet;

$R_0$ ein Wasserstoffatom und

$R_1$ ein Wasserstoffatom oder eine $C_1$-$C_6$-Alkylgruppe darstellen;

$R_2$ einen Rest der Formel

$$-[T]-\overset{\overset{\large O}{\|}}{C}-OR$$ oder 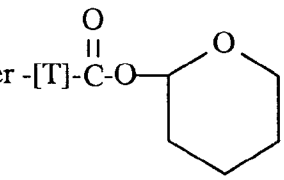

darstellt, worin

- R für einen tert.-Alkylrest mit 4 bis 19 Kohlenstoffatomen und
- [T] für eine $C_1$-$C_6$-Alkylengruppe stehen;
- $R_3$ und
- $R_4$ sowie
- $R_5$ und
- $R_6$ unabhängig voneinanander jeweils ein Wasserstoffatom oder eine $C_1$-$C_6$-Alkylgruppe darstellen; und
- $R_7$ ein Wasserstoffatom, eine Hydroxylgruppe, eine $C_1$-$C_6$-Alkylgruppe, eine Arylgruppe mit 6 bis 10 Ringkohlenstoffatomen oder eine Gruppe der Formel -[G]-O-$R_8$ darstellt, worin
- [G] für eine $C_1$-$C_6$-Alkylengruppe oder für eine Arylengruppe mit 6 Ringkohlenstoffatomen und
- $R_8$ für ein Wasserstoffatom, eine Trimethylsilylgruppe oder den Rest

$$-O-\overset{\overset{\large O}{\|}}{C}-CH_3$$

stehen;

oder

A zusammen mit $R_2$ eine Gruppe der Formel

$$-O-\underset{\underset{\large R_{12}}{|}}{\overset{\overset{\large R_{11}}{|}}{C}}-OR_{13}$$

darstellt, wobei

- $R_{11}$ sowie
- $R_{12}$ und
- $R_{13}$ die in Anspruch 1 angegebene Bedeutung haben.

**5.** Polymer nach Anspruch 4, bei dem

- $R_1$ ein Wasserstoffatom;
- $R_2$ einen Rest der Formel

$$-CH_2\overset{\overset{\large O}{\|}}{C}-OC(CH_3)_3$$

- $R_3$ und
- $R_4$ sowie
- $R_5$ und
- $R_6$ ein Wasserstoffatom und
- $R_7$ ein Wasserstoffatom, eine $C_1$-$C_6$-Alkylgruppe, eine Phenylgruppe, -$CH_2$OH oder

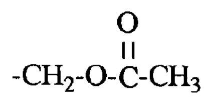

darstellen.

**6.** Polymer nach Anspruch 1 bis 5, das Struktureinheiten der Formel (II) enthält, worin
$R_7$

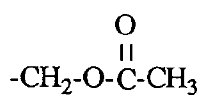

darstellt.

**7.** Polymer nach Anspruch 1 bis 6, bei dem das durchschnittliche Zahlenverhältnis von Struktureinheiten der Formel (Ia) und/oder (Ib) zu Struktureinheiten der Formel (II) im Molekül zwischen 5:1 und 1:1 liegt.

**8.** Als Positivphotoresist einsetzbare strahlungsempfindliche Zusammensetzung enthaltend
a) mindestens ein Polymer gemäss Anspruch 1 bis 7 und
b) mindestens eine unter der Einwirkung von aktinischer Strahlung säurebildende Verbindung.

**9.** Zusammensetzung gemäss Anspruch 8, enthaltend als weitere Komponente c) ein Lösungsmittel oder ein Lösungsmittelgemisch.

**10.** Zusammensetzung gemäss Anspruch 8 oder 9, enthaltend als Komponente b) mindestens eine Verbindung der Formel (IV)

$$(Ar_1)_q(Z_1)_r(Z_2)_s\ S^{\oplus}\ X_1^{\ominus} \qquad \text{(IV)},$$

worin
$Ar_1$ unsubstituiertes oder durch Halogen, $C_1$-$C_4$-Alkyl, $C_1$-$C_4$-Alkoxy, -OH und/oder Nitro substituiertes Phenyl, Naphthyl oder Phenyl-$COCH_2$- ist,
$Z_1$ $C_1$-$C_6$-Alkyl oder $C_3$-$C_7$-Cycloalkyl und
$Z_2$ Tetrahydrothienyl, Tetrahydrofuryl oder Hexahydropyryl sind,
q für 0, 1, 2 oder 3,
r für 0, 1 oder 2 und
s für 0 oder 1 stehen, wobei die Summe q+r+s 3 beträgt, und
$X_1^{\ominus}$ ein Chlorid-, Bromid- oder Iodidanion, $BF_4^{\ominus}$, $PF_6^{\ominus}$, $AsF_6^{\ominus}$, $SbF_6^{\ominus}$, $FSO^{\ominus}$ oder das Anion einer organischen Sulfonsäure oder Carbonsäure ist.

**11.** Zusammensetzung gemäss Anspruch 10, worin
$Ar_1$ Phenyl bedeutet,
q die Zahl 3 ist,
r und
s Null sind, und
$X_1^{\ominus}$ $SbF_6^{\ominus}$, $AsF_6^{\ominus}$, $PF_6^{\ominus}$, $CF_3SO_3^{\ominus}$, $C_2F_5SO_3^{\ominus}$, n-$C_3F_7SO_3^{\ominus}$, n-$C_4F_9SO_3^{\ominus}$, n-$C_6F_{13}SO_3^{\ominus}$, n-$C_8F_{17}SO_3^{\ominus}$ oder $C_6F_5SO_3^{\ominus}$ darstellt.

**12.** Zusammensetzung gemäss Anspruch 10, worin die Komponente b) Triphenylsulfoniumtrifluormethansulfonat ist.

**13.** Zusammensetzung gemäss Anspruch 8, enthaltend 0,1-20 Gew.-%, vorzugsweise 1-10 Gew.-%, der Komponente b), bezogen auf das Gewicht der Komponente a).

**14.** Verfahren zur Behandlung eines Substrats, das die folgenden Verfahrensmassnahmen in der angegebenen Reihenfolge umfasst:
1. Aufbringen einer Beschichtung bestehend aus einer Zusammensetzung gemäss Anspruch 8 bis 13 auf dem Substrat;

2. bildmässige Belichtung der Beschichtung mit Hilfe von aktinischer Strahlung;
3. Behandlung der Beschichtung mit einem Entwickler auf Basis einer wässerigalkalischen Lösung, bis sich der Strahlung ausgesetzte Partien der Beschichtung vom Substrat lösen und eine bildmässig strukturierte Beschichtung auf dem Substrat verbleibt.

**15.** Verfahren gemäss Anspruch 14, das zwischen Belichtung und Behandlung mit dem Entwickler die Erwärmung der Beschichtung als eine weitere Verfahrensmassnahme umfasst.

**16.** Verfahren gemäss Anspruch 14 oder 15, das als eine weitere Verfahrensmassnahme einen Behandlungsschritt, dem das die bildmässig strukturierte Beschichtung aufweisende Substrat zumindest auf der beschichteten Seite unterzogen wird und der an den freien Stellen des Substrats zu einer Veränderung des Substrats führt, und gegebenenfalls danach als eine zusätzliche Verfahrensmassnahme die Entfernung der strukturierten Beschichtung von dem Substrat umfasst.

**17.** Verfahren zur Herstellung eines elektronischen Bauelementes, das ein Verfahren gemäss Anspruch 14 bis 16 umfasst.

**18.** Unter Verwendung von Zusammensetzungen gemäss Anspruch 1 hergestellte Schutzschichten und Reliefstrukturen.